Europäisches Patentamt

European Patent Office

Office européen des brevets

(19)

(11) **EP 0 829 044 B1**

(12) **EUROPEAN PATENT SPECIFICATION**

(45) Date of publication and mention
of the grant of the patent:
**28.07.2004 Bulletin 2004/31**

(51) Int Cl.⁷: **G06F 9/312**, G06F 13/00,
G11C 16/06

(21) Application number: **95921471.9**

(22) Date of filing: **26.05.1995**

(86) International application number:
**PCT/US1995/006762**

(87) International publication number:
**WO 1996/037826 (28.11.1996 Gazette 1996/52)**

(54) **FLOATING GATE MEMORY DEVICE WITH PROTOCOL TO TERMINATE PROGRAM LOAD CYCLE**

SCHWEBEGATTERSPEICHERZELLE MIT PROTOKOLL ZUM BEENDEN DES
PROGRAMMLADEZYKLUS

MEMOIRE A PORTE FLOTTANTE A PROTOCOLE DE TERMINAISON DU CYCLE DE
CHARGEMENT DE PROGRAMMES

(84) Designated Contracting States:
**DE FR GB IT**

(43) Date of publication of application:
**18.03.1998 Bulletin 1998/12**

(73) Proprietor: **Macronix International Co., Ltd.**
**Hsinchu (TW)**

(72) Inventors:
• **YIU, Tom, Dang-Hsing**
**Milpitas, CA 95035 (US)**
• **WAN, Ray-Lin**
**Milpitas, California (US)**
• **CHENG, Yao-Wu**
**Taipei (TW)**
• **HUNG, Chun-Hsiung**
**Hsinchu (TW)**
• **SHONE, Fuchia**
**Hsinchu (TW)**

(74) Representative: **Horner, David Richard**
**D Young & Co,**
**21 New Fetter Lane**
**London EC4A 1DA (GB)**

(56) References cited:
JP-A- 4 221 496          JP-A- 5 182 482
US-A- 4 970 692          US-A- 5 036 460
US-A- 5 053 990          US-A- 5 109 492
US-A- 5 355 464          US-A- 5 414 664
US-A- 5 414 829

• KRUECKEBERG J: "ZWEIGETEILTES EEPROM:
GLEICHZEITIG AUSLESEN UND
BESCHREIBEN" ELEKTRONIK, vol. 39, no. 26,
21 December 1990 (1990-12-21), pages 56-59,
XP000177694 ISSN: 0013-5658
• TOSHIHIRO TANAKA ET AL: "HIGH-SPEED
PROGRAMMING AND PROGRAM-VERIFY
METHODS SUITABLE FOR LOW -VOLTAG
FLASH MEMORIES" SYMPOSIUM ON VLSI
CIRCUITS. DIGEST OF TECHNICAL PAPERS,
HONOLULU, JUNE 9 - 11, 1994,9 June 1994
(1994-06-09), page 61/62 XP000501022
INSTITUTE OF ELECTRICAL AND
ELECTRONICS ENGINEERSISBN:
0-7803-1919-2

Note: Within nine months from the publication of the mention of the grant of the European patent, any person may give
notice to the European Patent Office of opposition to the European patent granted. Notice of opposition shall be filed in
a written reasoned statement. It shall not be deemed to have been filed until the opposition fee has been paid. (Art.
99(1) European Patent Convention).

EP 0 829 044 B1

**Description**

BACKGROUND OF THE INVENTION

Field of the Invention

The present invention relates to floating gate memory devices, such as flash EPROM or EEPROM, and more particularly to such devices having automatic program cycles for programming a block of data.

Description of Related Art

Floating gate memory devices, such as flash memory and EEPROM, provide for electrically storing data into the device. The operation of storing data has been controlled in the prior art based on commands which consist of a sequence of addresses or data, such as described in prior art U.S. Patent No. 4,970,692, to Ali, *et al.*, When a particular sequence of addresses is detected, in combination with the appropriate cycling of the chip enable and write enable signals, an automatic program mode is initiated in one prior art system. The automatic program mode includes a program load cycle in which the chip receives a stream of addresses and data which are loaded into a programming data buffer. After the block of data to be programmed has been loaded into the buffer, an automatic program cycle is executed by state machines on the chip to transfer the data into the non-volatile memory array. The problem arises in detecting the end of the block of data to be stored. In prior art systems, the end of the block of data is signaled by a pulse of the chip enable or write enable signal which lasts more than 100 microseconds. The prior art devices require further that the full buffer (i.e. 256 bytes) be loaded prior to programming.

The time out sequence, based on the long 100 microsecond pulse, is time consuming and can cause problems in computer systems. For instance, interrupt signals may occur while the memory device is doing the loading of the buffer. In this case, if the interruption is longer than the 100 microsecond waiting period, then the internal state machine on the flash memory may take over and program the data in the buffer, before the entire buffer is loaded. Thus, care must be taken in systems using flash memory to prevent interrupts which take longer than 100 microseconds to service. If the duration of interrupt servicing cannot be managed, then a problem arises which cannot be addressed using prior art systems.

US-A-4,970,692 describes a circuit for controlling a flash EEPROM having three distinct modes of operation by allowing multiple functionality of a single pin. The EEPROM device includes decoding means for determining from a received address whether a programming mode or an erase mode should be entered.

Accordingly, it is desirable to provide a protocol which allows for loading a block of data having an arbitrary length into a floating gate memory device, and for detecting when the end of that block has been loaded.

SUMMARY OF THE INVENTION

The present invention provides a protocol which terminates a program load cycle in an integrated circuit memory, providing positive indication of the end of the load cycle, and eliminating the requirement for a long pulse in a control signal. The invention is based on command logic which executes a process to store a block of data in response to a sequence of addresses and data segments received at the input/output circuitry, and monitors the sequence to detect a pattern indicating an end of the block of data, the pattern including at least one of the addresses and data segments received at the input/output circuitry. Thus, according to one embodiment of the invention the pattern includes an address transition between consecutive matching addresses. The command logic of this embodiment includes a circuit coupled to the input/output circuitry which stores addresses in the sequence and compares them with a next address to indicate a matching address. Alternatively, the pattern may include both matching addresses and data segments with corresponding comparator circuitry. Alternatively, the pattern may comprise a transition to a command address which is outside the address field of the memory array, or a transition of part of an address from a command value to a read value for the page. To terminate the program load cycle, the host simply sends the required pattern, such as by repeating the last address/data segment in the block. No 100 microsecond pulse is required; and a positive, quick indication that the end of the block has been reached is provided.

The integrated circuit memory according to one embodiment includes a state machine which automatically programs and verifies programming of the block of data after the last segment of the block is detected.

In another alternative, the input/output circuitry receives a control signal, such as a write enable or chip enable signal, which establishes the timing for the sequence of addresses and data segments. The command logic includes a circuit to detect a pulse from the control signal having a characteristic pulse width as another way to indicate that the block is completely loaded for instance to be compatible with prior art systems. The command logic automatically programs and verifies programming of the block after the last segment in the block is detected based on pattern matching or the long pulse is detected.

The present invention is particularly applicable to floating gate memory devices which provide for page programming. According to one such embodiment, the memory provides a memory array of floating gate cells. The memory array includes a plurality of word lines and bit lines which are coupled to the floating gate cells in the array. Input circuitry is included which has inputs to receive addresses and data. Command logic is coupled to the input circuitry, which initiates the program process in response to a sequence of addresses and data segments received at the input circuitry, including logic to detect a last segment in the block of data in response to a pattern including at least one of addresses and data received at the input circuitry. A page buffer is included in the circuit, which is coupled to the input circuitry to store the block of data and supply the block of data to the floating gate cells in the array. Write control circuitry is coupled to the command logic, the page buffer and the word lines, which after detection of the last segment in the block, supplies programming voltages to a selected wordline for programming input data to a row of floating gate cells accessed by the selected word line in response to the input data stored in the page buffer. Finally, program/verify circuitry is included coupled with the page buffer, which verifies that the floating gate cells are programmed with the block of data in the page buffer.

In a preferred system, the page buffer includes a plurality of bit latches coupled to corresponding ones of the plurality of bit lines. The program verify circuitry includes logic coupled to the page buffer and to the bit lines, that resets bit latches to a first binary value when stored data in the floating gate cell on a corresponding bit line matches a second binary value.

In one embodiment of the present invention, a method is provided for storing a block of data consisting of less than or equal to a page in a floating gate memory device. The method of this embodiment includes the following:

supplying a command which indicates an automatic program operation to the memory device;
after supplying the command, supplying a stream of addresses and segments of data, and storing the supplied segments of data in a page buffer;
monitoring the stream of addresses and segments of data to detect a pattern in the stream which signals an end of the block of data; and
after detection of the pattern, executing a program operation to store the block of data from the page buffer.

Accordingly, embodiments of the present invention provides a protocol to terminate a program load cycle for a floating gate memory device, such as flash memory or EEPROM, which relies on a pattern of addresses and/or data signals to signal the end of the load cycle. The protocol provides for positive indication of the end of the load cycle, so that a block of data of arbitrary length up to the size of a page can be loaded for each program cycle. Also, it eliminates the requirement of the 100 microsecond pulse used in the prior art, and is therefore inherently faster and less vulnerable to long interruptions in the cycling of the control signals.

Other aspects and advantages of the present invention can be seen upon review of the figures, the detailed description, and the claims which follow.

BRIEF DESCRIPTION OF THE FIGURES

Fig. 1 is a schematic block diagram of a floating gate memory device including the pattern match logic of the present invention for indicating the termination of a program load cycle.
Fig. 2 illustrates the sequence used in prior art systems to indicate the end of a program load cycle.
Fig. 3 illustrates the timing according to the present invention for indicating the end of a program load cycle.
Fig. 4 is a first part of the logic for detecting matching input addresses according to the present invention.
Fig. 5 is a second part of the logic used for indicating a matching sequence of addresses received at the input buffers according to the present invention.
Fig. 6 is a timing diagram for the control signals used in the system of Figs. 4 and 5.
Fig. 7 is a circuit diagram of a floating gate memory array which can be used in the system of the present invention.
Fig. 8 is a block diagram of a flash EEPROM array including page program buffers and a mode control state machine including the protocol of the present invention.
Fig. 9 is a logic diagram of the page buffer bit latches in the system of Fig. 8.
Fig. 10 is a flow chart for the program operation according to the present invention.
Figs. 11A and 11B show alternative address patterns used to signal the end of a page load cycle according to the present invention.

DETAILED DESCRIPTION

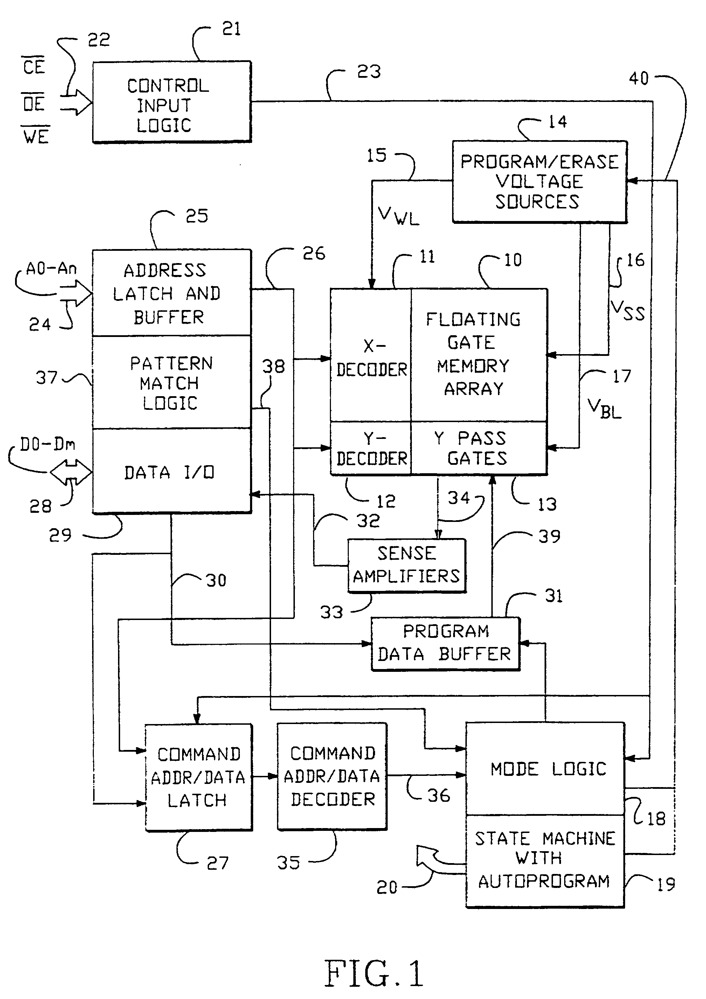

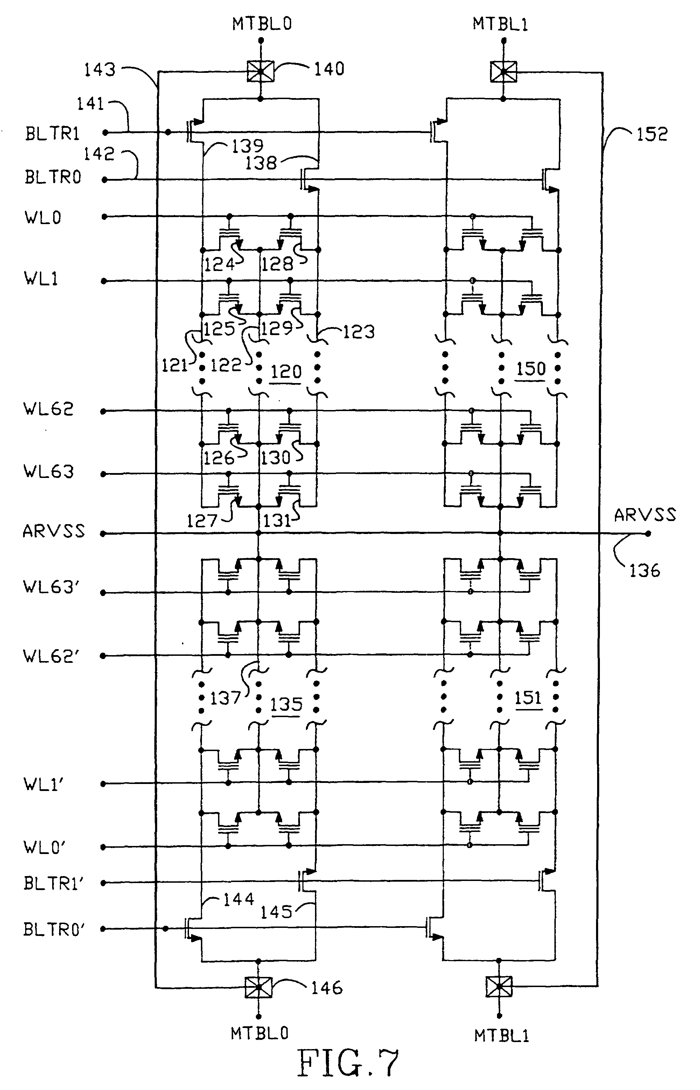

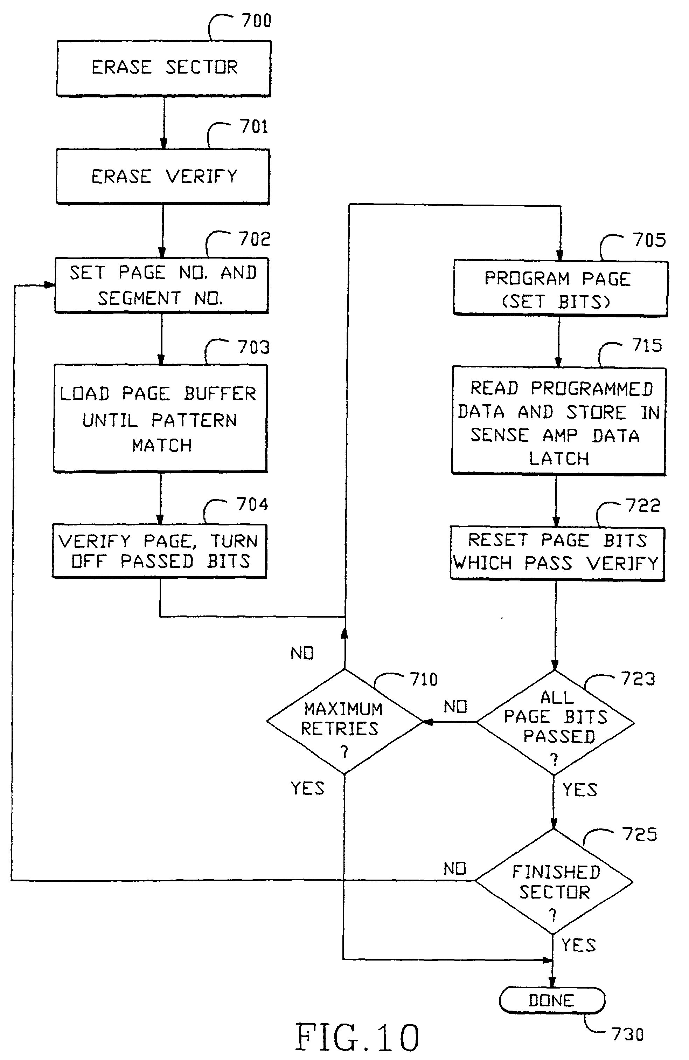

A detailed description of a preferred embodiment of the present invention is provided with respect to Figs. 1 through 10A and 10B, in which Figs. 1 through 6 illustrate the basic architecture of a memory device implementing the protocol to terminate a program load cycle according to the present invention based on pattern match logic. Figs. 7 through 10A and 10B illustrate a page program flash EEPROM device which includes the protocol of the present invention.

Fig. 1 is a block diagram representing a basic floating gate memory device for an integrated circuit which includes the logic for terminating a load cycle according to the present invention. Fig. 1 is a simplified drawing of the basic components of a floating gate memory device formed on an integrated circuit. It is meant to represent the components of commercially available flash EPROM or EEPROM devices, which are supplemented with the novel pattern match logic. and protocol logic for determining the end of the program load cycle of the present invention.

Thus. the device includes a floating gate memory array 10. Coupled with the array are an X decoder 11, a Y decoder 12. and Y pass gates 13. Program and erase voltage sources 14 are coupled with the array to supply a voltage on line 15 for word lines being programmed or erased, a voltage on line 16 for source terminals of cells in the array being programmed or erased, and a voltage on line 17 for bit lines coupled to cells being programmed or erased in the array. The mode control logic 18 and state machine 19 are connected by line 40 to the program and line voltage sources 14, among other places. The mode control logic 18 and state machine 19 including an automatic program function. are included on the chip to control the read, erase, and program operations as known in the floating gate memory art. The state machine generates control signals generally represented by arrow 20 which manage the various operations of the device. The mode control logic is responsive to control signals received at control input logic 21 on the chip. The control inputs include, for example, a chip enable $\overline{CE}$, an output enable $\overline{OE}$, and a write enable $\overline{WE}$ signal on inputs represented by arrow 22. The control input logic supplies control signals on line 23 to the mode logic 18. Addresses are received on input bus 24, and supplied to an address latch and buffer 25. The addresses at the output of the address latch and buffer 25 are supplied on line 26 to the X decoder 11, the Y decoder 12, and to a command address/data latch 27. Input data and output data are supplied on I/O pins represented by arrow 28 through data I/O circuitry 29. The incoming data is supplied on line 30 to the command address/data latch 27, and to a program data buffer 31. Output data is received on line 32 from sense amplifiers 33, which are coupled to the Y pass gates 13 across line 34 to receive read data.

The command address/data latch 27 is coupled to a command address/data decoder 35, which decodes patterns in the incoming address and data stream which indicate certain functions to be performed. The output of the decoder is supplied on line 36 to the mode logic 18. which manages the various operations.

According to the present invention one of the operations is an autoprogram mode which involves automatically loading into the program data buffer and storing a block of data. with an automatic program verify operation.

According to the present invention, pattern match logic 37 is coupled with the address latch and buffer 25, and the data I/O circuitry 29 to indicate during the program load cycle of the autoprogram operation when the incoming stream of addresses and data segments match a pre-specified pattern, such as consecutive matching addresses, consecutive matching address/data segment combinations, or an address which matches a pre-specified command address outside the address space used in programming the floating gate memory array 10.

The output of the pattern match logic is supplied on line 38 to the mode logic 18 to signal the end of the program load cycle. At the end of the program load cycle, the state machine initiates the autoprogram process, storing the data from the program data buffer 31 across line 39 into the floating gate memory array 10, and automatically verifying the programming operation.

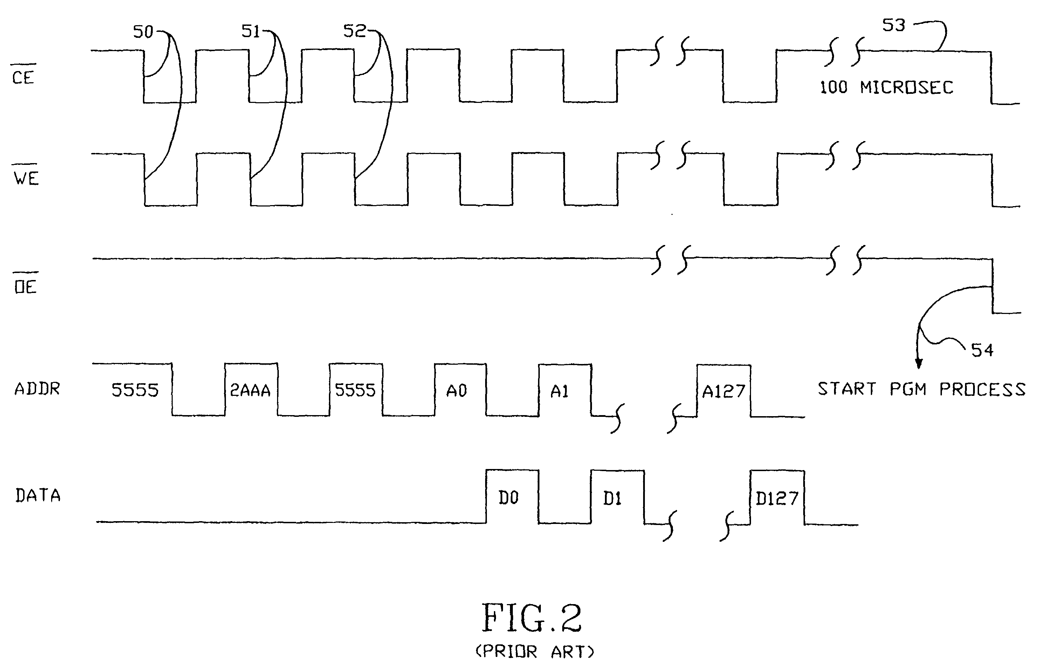

Fig. 2 illustrates the prior art protocol timing for determining the end of the program load cycle. According to the prior art, to initiate a program load cycle, the chip enable and write enable signals are toggled from high to low as indicated at point 50. When these signals are toggled from high to low, an input address such as hex 5555 is latched in the command address/data latch 27. In the next toggle of these signals from high to low, as indicated at point 51, a second address in the command sequence is loaded, such as hex 2AAA. The third address in the command sequence is loaded at point 52, such as hex 5555. After this sequence, the autoprogram cycle is initiated by the mode control logic 18. On each succeeding falling edge of the chip enable or write enable signal, a new address is received, such as A0, A1 ..., A127, for a case in which there are 128 addresses in a page of data to be stored in the program data buffer 31.

On each rising edge following a particular falling edge, the data segment for the previous address is loaded. such as data segments D0, D1, ... D127. In the prior art, after all data segments for the program data buffer 31 are loaded, then a pulse of at least 100 microseconds, such as the pulse 53, in one of the control signals is issued. After the 100 microsecond pulse, the program process for the stored data is initiated as indicated by the arrow 54 by a transition in the output enable $\overline{OE}$ signal. As discussed above in the background section of the present application, this protocol suffers the disadvantage that all segments of data in the page must be loaded for any program cycle, and the disadvantage that the 100 microsecond pulse is required to initiate the program process.

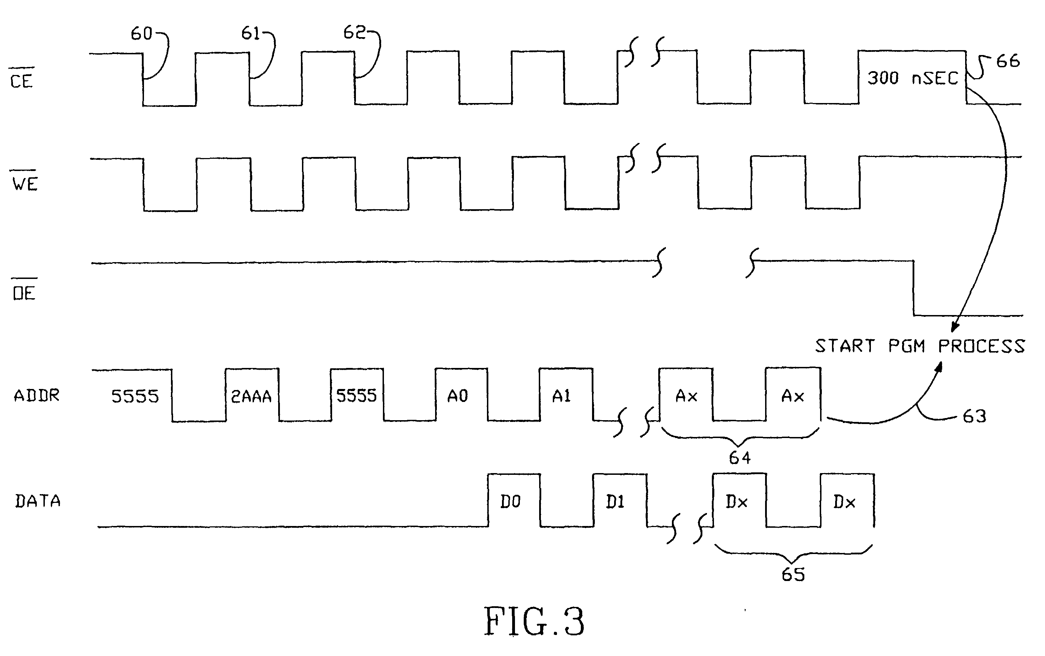

Fig. 3 shows the protocol timing according to the present invention. As before, an address sequence corresponding to a command is latched on the first three falling edges of the control signals, such as at edges 60, 61, and 62. After the command sequence indicates the automatic program cycle, then a program load operation is executed in which the addresses A0, A1 through Ax are loaded on sequential falling edges of the control signal. On sequential rising edges of the control signal, the corresponding data segments D0 through D1, ... Dx are loaded.

According to the present invention when a pre-specified pattern of addresses and/or data is detected, then the program process is begun as indicated by arrow 63. A 300 nanosecond pulse ending at edge 66 is required in this embodiment for synchronization of the state machine before the autoprogram process starts. Thus, in the illustration shown in Fig. 3 the pattern includes two sequential addresses in the address stream which match. such as Ax followed by Ax as shown in the region 64. Also, matching sequential data for the corresponding addresses as shown in the sequence 65 may be required to indicate the end of the program load segment of the autoprogram process.

This process allows for explicit indication of the end of the program load segment of the autoprogram process upon an address or data transition in the sequence. The length of the block of data being loaded can be arbitrary, from 1 byte to the full size of the page buffer.

Alternative sequences involve simply matching addresses, without requiring matching data in the stream. Alternatively, a pre-specified command address can be identified, which when occurring in an address stream during the program load process, indicates the end of the stream. This command address should fall outside the address space used in the program load process.

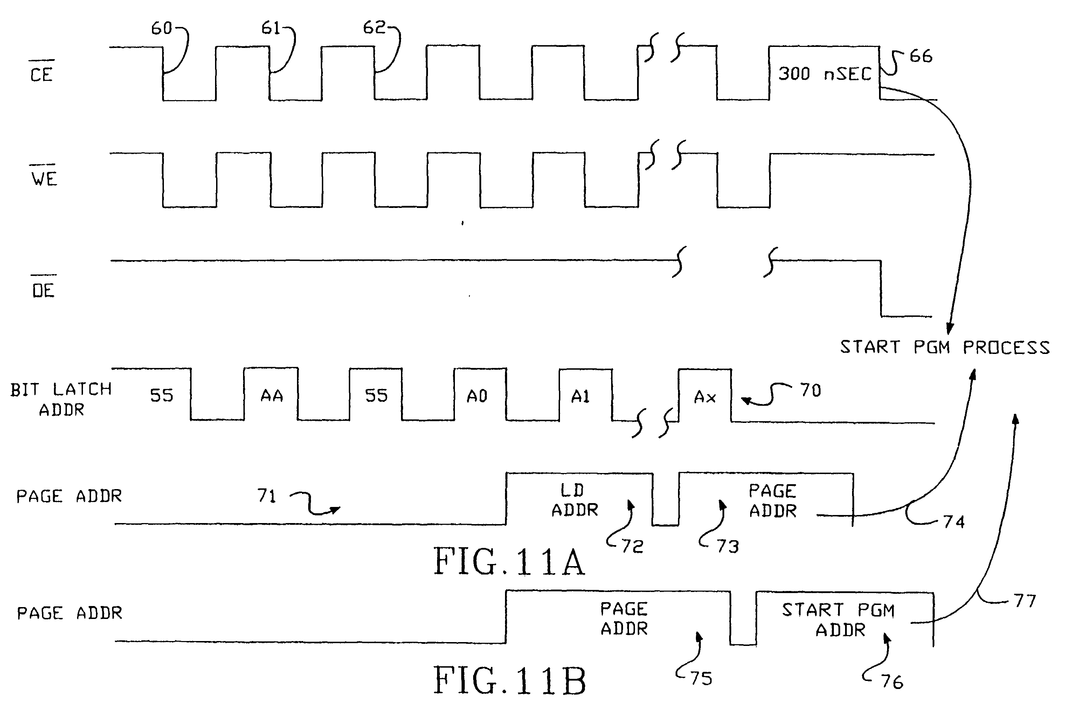

Figs. 11A and 11B show an alternative pattern for detecting the end of the page load process. The locations into which data is to be stored are identified by addresses within an address field for the memory device. The addresses have a page address segment and page buffer address segment. In Fig. 11A, the page buffer (or bit latch) address segment is identified by trace 70 while the page address is indicated by trace 71. As in Fig. 3, the control signals including chip enable, write enable, and output enable are switched as shown in the figure. The same reference numerals used in Fig. 3 are used in Fig. 11A where appropriate.

To begin a load cycle sequence according to this aspect of the invention, the command sequence is latched on the edges 60, 61, and 62 as before. The low order address field which stores the bit latch address will include a portion of the command code as indicated. The high order address field will include the balance of the command code (not shown). As seen in Fig. 3, the address command code to begin the load process is actually a 15 bit address (A0 to A14) rather than the 8 bit addresses indicated by the hex values 55, AA, and 55 of Fig. 11A. These two higher order fields of the command sequence could be included in the page address field shown along trace 71, or included in a field that is intermediate between the bit latch address and the page address depending on a particular implementation.

According to the pattern shown in Fig. 11A, after initiation of the load process in response to the command sequence 55, AA, 55. a dummy load address is supplied to the page address field during the interval 72. The dummy load address 72 is latched in the fourth cycle of the sequence. along with the first bit latch address A0. This load address is held constant while the sequence of bytes and bit latch addresses are loaded to define the block to be stored. In Fig. 11A, the data values are not shown. However, they will be timed just as shown in Fig. 3. In order to indicate the end of the load sequence, as shown in Fig. 11A, before the last address Ax in the sequence, the page address field on trace 71 is changed from the dummy load address 72 to the actual page address 73 within the address field for the memory. The command logic detects this transition from the dummy load address to the page address, and starts the program process as indicated by arrow 74. As in the case of the pattern of Fig. 3, a 300 nanosecond pulse ending by transition 66 in the chip enable signal is used to ensure that the state machine is synchronized to begin the programming process.

The pattern of Fig. 11A has the advantages that it does not require an extra dummy cycle in which the address and/or data are repeated as shown in Fig. 3.

Fig. 11B shows another alternative pattern which uses the page address segment of the addresses being received to indicate the end of the load cycle. According to this alternative, after detection of the command sequence indicating an automatic program, the actual page address for the data being loaded is latched as indicated in field 75. The actual page address is latched in the fourth cycle of the sequence along with the bit latch address A0. After the last byte in the sequence is loaded having the address Ax, then the page address is changed to a dummy start program address 76 which is outside the address field for the memory. The dummy start program address is detected by the command logic. which then initiates the program process as indicated by arrow 77. The 300 nanosecond pulse of the chip enable signal may be necessary again to ensure synchronization of the circuitry.

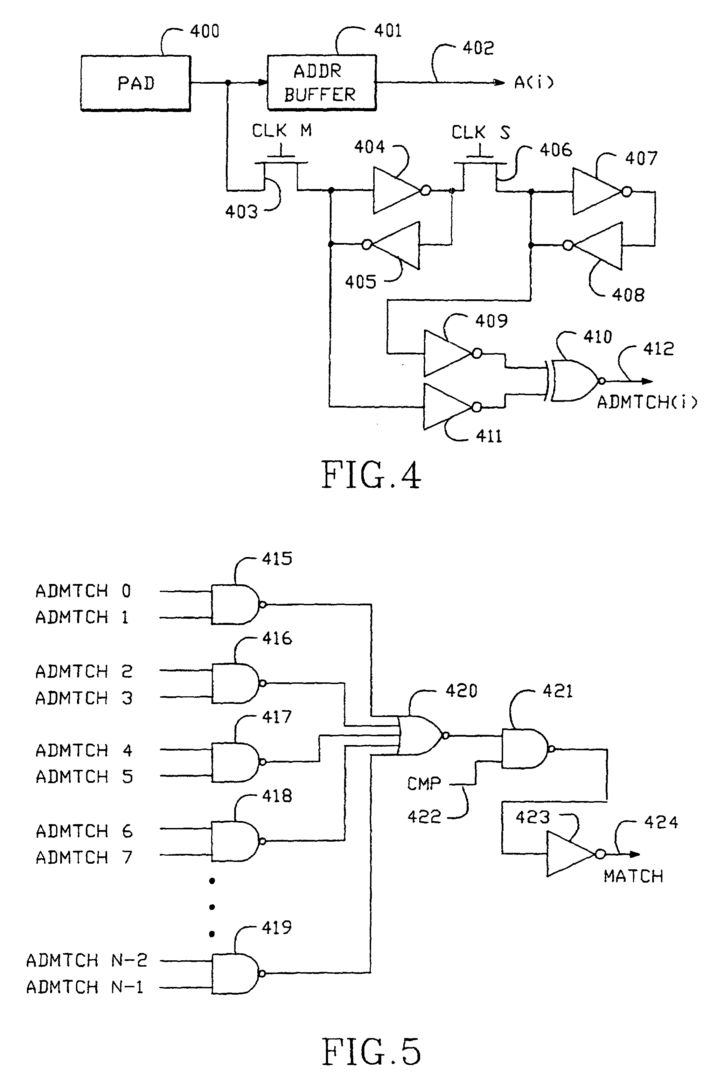

With reference to Figs. 4, 5, and 6, pattern match logic for the incoming address and data stream is described. The logic of Figs. 4, 5, and 6 is applied to an address input buffer. Identical circuitry can be used with a data input buffer when data matching is required. and is not described again. Thus, as shown in Fig. 4, an address input pad 400 is included on the chip. The signal on the pad 400 is supplied to an address buffer 401. The output of the address buffer is the address bit A(i) on line 402. The address pad 400 is also connected through a pass gate 403 which is controlled by the signal CLKM. The output of the pass gate 403 is supplied to a latch made up of inverters 404 and 405. The output of the latch is supplied through a pass gate 406 which is controlled by the CLKS. The output of pass gate 406 is supplied to a latch composed of inverters 407 and 408. The data in the latch made up inverters 407 and 408 is supplied through inverter 409 to an exclusive NOR gate 410. Also the data in the latch composed of inverters 404 and 405 is supplied through inverter 411 as a second input to the exclusive NOR gate 410. The output of the exclusive NOR gate 410 indicates an address match for the bit supplied on the pad 400, as indicated by the signal ADMTCH (i) on line 412.

All of the address match signals ADMTCH 0 through N-1 (where N is the number of address bits) are supplied to the circuitry shown in Fig. 5. Thus, the match signals for bits 0 and 1 are supplied to NAND gate 415, and for bits 2 and 3 are supplied to NAND gate 416. The address match signal for bits 4 and 5 are supplied to NAND gate 417. Address match signals for bits 6 and 7 are supplied to NAND gate 418, and so on, until address match signals for bit N-2 and for bit N-1 are supplied to NAND gate 419. The output of the NAND gates 415 through 419 are supplied to a multiple input NOR gate 420. The output of the NOR gate is supplied through NAND gate 421. which receives as a second input a compare clock signal CMP on line 422. The output of NAND gate 421 is supplied through inverter 423 as a match signal on line 424, which is in turn supplied to the mode logic to indicate the detection of the sequential matching addresses.

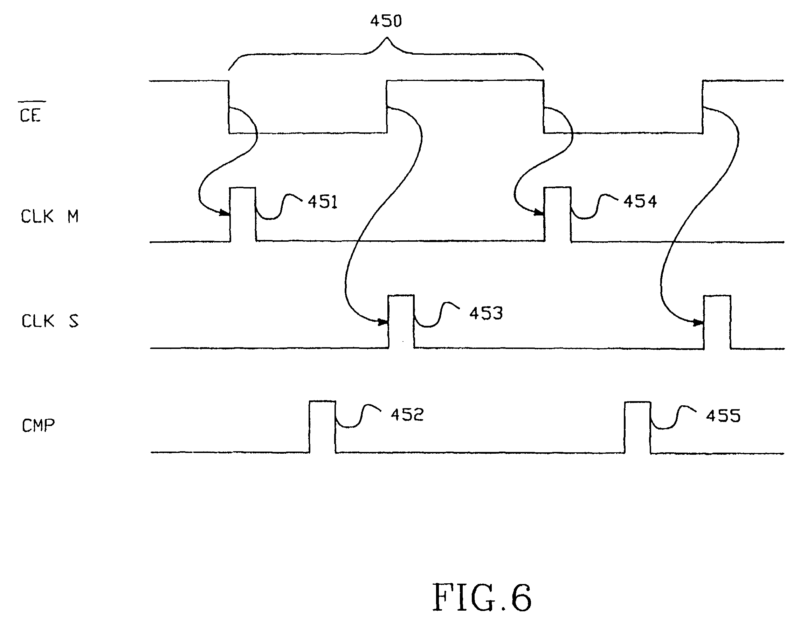

The timing of the control signals CLKM, CLKS. and CMP is illustrated in Fig. 6 with reference to the chip enable control signal $\overline{CE}$. Thus, the CLKM signal includes a pulse at the falling edge of the chip enable signal. The signal CLKS includes a pulse at the rising edge of the chip enable signal. The control signal CMP is a pulse issued after the falling edge and before the rising edge of the chip enable signal, beginning after detection of the command sequence to start the autoprogram operation The signal CMP is disabled during the first address and data loading cycle. Thus, in a given cycle, such as cycle 450 of the chip enable signal, a current address in the sequence is latched through the pass gate 403 into the latch composed of inverters 404 and 405 in response to the CLKM signal pulse 451. Between the falling edge and the rising edge, the CMP pulse 452 is issued which causes comparison of the address match signals, to occur between a previous address, and the current address which has just been latched. On the rising edge of the chip enable signal, the current address is shifted through the pass gate 406 in response to the CLKS pulse 453 into the latch composed of inverters 407 and 408. On the following falling edge the CLKM pulse 454 is issued. This causes the current address to be stored in the latch composed of inverters 404 and 405, while the previous address in the stream is stored in the latch composed of inverters 407 and 408. The current and the previous addresses are compared in response to the CMP signal pulse 455.

Although the logic of Figs. 4 and 5 is shown for the address signals, the same logic is used for data signals, if the pattern to be detected includes matching segments of data in the stream.

This logic can be adapted as known in the art to detect a variety of patterns of data occurring in the address and data stream which suits the needs of the particular implementation. Furthermore, the latch composed of inverters 407 and 408 might be replaced by a non-volatile store which holds a bit of a command address as discussed above, which falls outside the address space used in the program load operation, to be matched with the incoming data stream.

Fig. 7 illustrates an architecture of a segmentable flash EEPROM array according to the present invention, in which two columns of flash EEPROM cells share a single metal bit line. Fig. 7 shows four pairs of columns of the array. where each pair of columns includes flash EEPROM cells in a drain-source-drain configuration.

Thus, the first pair 120 of columns includes a first drain diffusion line 121, a source diffusion line 122, and a second drain diffusion line 123. Word lines WL0 through WL63 each overlay the floating gates of a cell in a first one of the pairs of columns and a cell in the second one of the pairs of columns. As shown in the figure, a first pair 120 of columns includes one column including cell 124, cell 125, cell 126, and cell 127. Not shown are cells coupled to word lines WL2 through WL61. The second one of the pair 120 of columns includes cell 128, cell 129, cell 130, and cell 131. Along the same column of the array, a second pair 135 of columns is shown. It has a similar architecture to the pair 120 of columns except that it is laid out in a mirror image.

Thus, as can be seen, the transistor in the first one of the pair of columns, such as the cell 125, includes a drain in drain diffusion line 121, and a source in the source diffusion line 122. A floating gate overlays the channel region between the first drain diffusion line 121 and the source diffusion line 122. The word line WL1 overlays the floating gate of the cell 125 to establish a flash EEPROM cell.

The column pair 120 and column pair 135 share an array virtual ground diffusion 136 (ARVSS). Thus, the source diffusion line 122 of column pair 120 is coupled to the ground diffusion 136. Similarly, the source diffusion line 137 of column pair 135 is coupled to the ground diffusion 136.

As mentioned above, each pair 120 of columns of cells shares a single metal line. Thus, a block right select transistor 138 and a block left select transistor 139 are included. The transistor 139 includes a drain in the drain diffusion line 121, a source coupled to a metal contact 140, and a gate coupled to the control signal BLTR1 on line 141. Similarly, the right select transistor 138 includes a source in the drain diffusion line 123, a drain coupled to the metal contact 140, and a gate coupled to the control signal BLTR0 on line 142. Thus, the select circuitry, including transistors 138 and 139, provides for selective connection of the first drain diffusion line 121 and a second drain diffusion line 123 to the metal line 143 (MTBL0) through metal contact 140. As can be seen, column pair 135 includes left select transistor 144 and right select transistor 145 which are similarly connected to a metal contact 146. Contact 146 is coupled to the same metal line 143 as is contact 140 which is coupled to column pair 120. The metal line can be shared by more than two columns of cells with additional select circuitry.

The architecture shown in Fig. 7 is based upon a drain-source-drain unit forming two columns of cells which are isolated from adjacent drain-source-drain units to prevent leakage current from adjacent columns of cells. The architecture can be extended to units of more than two columns, with appropriate tolerances for leakage current in the sensing circuitry, or other controls on current leakage from unselected cells. Thus, for instance, fourth and fifth diffusion lines could be added within a given isolated region to create a drain-source-drain-source-drain structure which provides four columns of cells.

Column pairs are laid out horizontally and vertically to provide an array of flash EEPROM cells comprising M word lines and 2N columns. The array requires only N metal bit lines each of which is coupled to a pair of columns of flash EEPROM cells through select circuitry, as described above.

Although the figure only shows four column pairs 120, 135, 150, and 151, coupled to two metal bit lines 143 and 152 (MTBL0-MTBL1), the array may be repeated horizontally and vertically as required to establish a large scale flash EEPROM memory array. Thus, column pairs 120 and 150 which share a word line are repeated horizontally to provide a segment of the array. Segments are repeated vertically. A group of segments (e.g., eight segments) having respective word lines coupled to a shared word line driver may be considered a sector of the array.

The layout of the array is compact because of the virtual ground configuration, the reduced metal pitch requirement for the layout, and further by the ability to share word line drivers amongst a plurality of rows in different segments. Thus, word line WL63' may share a word line driver with word line WL63. In a preferred system, eight word lines share a single word line driver. Thus, only the pitch of one word line driver is needed for each set of eight rows of cells. The additional decoding provided by the left and right select transistors (139, 138 for segment 120) allows the shared word line configuration. The shared word line configuration has the disadvantage that during a sector erase operation. eight rows of cells all receive the same word line voltage, causing a word line disturbance in cells that are not desired to be erased. If it is a problem for a given array, this disturbance problem can be eliminated by insuring that all sector erase operations decode for segments including all rows of cells coupled to the shared word line drivers. For eight word lines sharing a single driver, a minimum sector erase of eight segments may be desired.

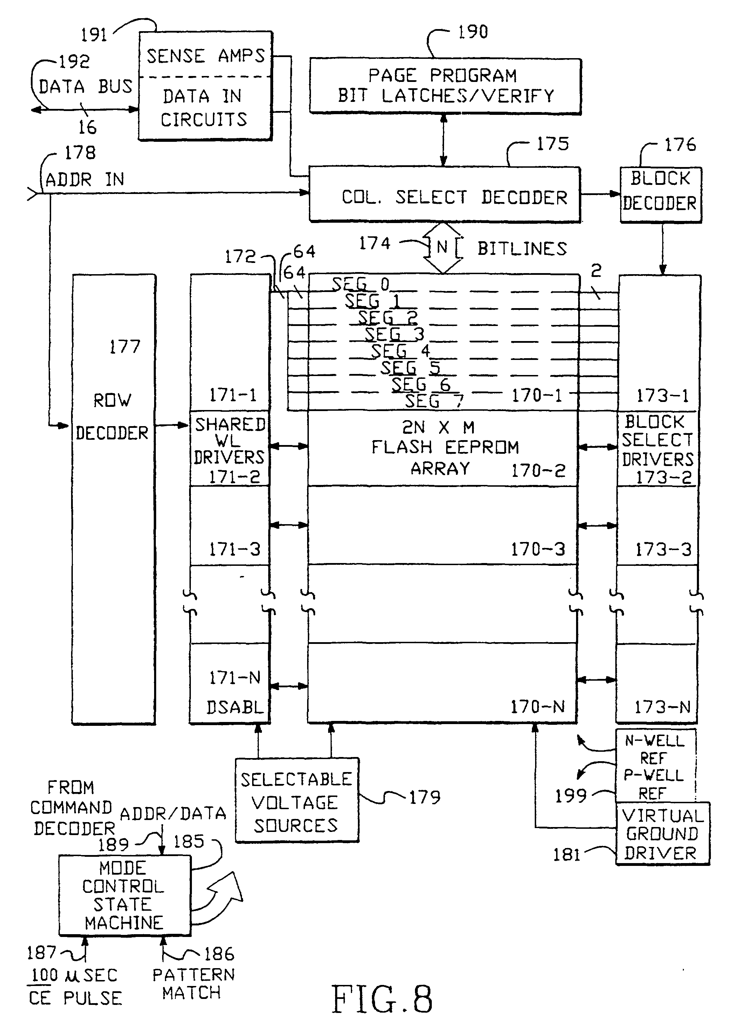

Fig. 8 is a schematic block diagram of a flash EEPROM array including a page mode programming function meant to illustrate certain features of the present invention. Thus, the flash EEPROM memory module shown in Fig. 8 includes a main flash EEPROM array. including sectors 170-1,170-2, 170-3, 170-N, each sector including eight segments (e.g., SEGO-SEG7). A plurality of sets of shared word line drivers 171-1, 171-2, 171-3, 171-N are used to drive the shared word lines of the eight segments in the respective sectors. As illustrated with respect to shared word line drivers 171-1, there are 64 shared drivers for sector 170-1. Each of the 64 drivers supplies an output on line 172. Each of these outputs is used to drive eight word lines in respective segments of the sector 170-1 as schematically illustrated in the figure by the division into eight sets of 64 lines.

Also coupled to the array are a plurality of block select drivers 173-1, 173-2, 173-3, 173-N. The block select drivers each drive a left and right block select signal for each segment. Where the segments are implemented as shown in Fig. 7, there is a BLTR1 and BLTR0 block select signal pair supplied for each set of 64 word lines.

In addition, there are N global bit lines in the flash EEPROM array. The N bit lines are used to allow access to the 2N columns of flash EEPROM cells in the array for the data in circuitry and sense amps 191. The column select decoder 175 is coupled to the page program bit latches 190, including at least one bit latch for each of the N bit lines. Also, the column select decoder 175 is coupled to the data in circuitry and sense amps 191. Data bus line 192 is 16 bits wide and provides input data to the data in circuitry and sense amps 191. Data bus line 192 also provides 16 bits of output data. Together, these circuits provide data in and out circuitry for use with the flash EEPROM array.

The N bit lines 174 are coupled to a column select decoder 175. In a preferred system, N = 1024 for a total of 1024 bit lines. The block select drivers 173-1 through 173-N are coupled to a block decoder 176. The shared word line drivers 171-1 through 171 -N are coupled to row decoder 177. The column select decoder 175, block decoder 176, and row decoder 177 receive address signals on the address in line 178.

Coupled to the column select decoder 175 is page program bit latches/verify block 190. The page program bit latches/verify block 190 includes N latches, one for each of the N bit lines. Thus. a page of data may be considered N bits wide, with each row of cells two pages, page 0 and page 1, wide. Pages in a given row are selected using the left and right decoding described above. The page program bit latches/verify block 190 includes verify circuitry for data stored in the N bit latches and the N bits wide page of data programmed to a selected row of cells in the array. An example of this circuitry is described below.

Selectable voltage sources 179 are used to supply the reference potentials for the read, program, and erase modes for the flash EEPROM array as conceptually illustrated in the figure, through the word line drivers 171-1 to 171-N and through the bit lines.

The virtual ground lines in the array are coupled to the virtual ground driver 181 providing potentials for the various modes to the virtual ground terminals in the array. Also, p-well and n-well reference voltage sources 199 are coupled to the respective wells of the array.

Thus, as can be seen in Fig. 8, the 64 word line drivers, such as word line drivers 171-1, are used with 512 (64 x 8) rows in the array. The additional decoding provided by the block select drivers (e.g., 173-1) allow for the shared word line layout.

The cells in the preferred embodiment are configured for a sector erase operation that causes charging of the floating gate (electrons entering the floating gate) such that upon sensing an erased cell, and the cell is nonconducting. Also, the architecture is configured for a page program which involves discharging a floating gate (electrons leaving the floating gate) such that upon sensing, a programmed cell is conducting.

Also shown in Fig. 8 is a mode control state machine 185, which controls operation of the device for reading, programming, and erasing. The inputs to the mode control state machine, such as described above with respect to Fig. 1, include the pattern match signal on line 186. Also, an input on line 189 is supplied from the command address/data decoder as mentioned before. This provides for detecting the end of a program load cycle in an automatic program operation using the page program bit latches/verify circuitry, in response to the pattern match signal on line 186. For compatibility, a 100 microsecond chip enable pulse can be indicated as pointed out by line 187. However, this may not be necessary for a particular implementation.

The operation voltages for the programming operation are positive 6 volts to the drain of a cell to be programmed to a low (data = 0) threshold condition, negative 8 volts to the gate, and 0 volts or floating of the source terminal. The substrate or the p-well of the cell is grounded. This results in a Fowler-Nordheim tunneling mechanism for discharging the floating gate.

The erase operation is executed by applying negative 8 volts to the source, and positive 12 volts to the gate, with the drain left floating. The p-well is biased at negative 8 volts. This results in a Fowler-Nordheim tunneling mechanism to charge the floating gate. The read potentials are 1.2 volts on the drain, 5 volts on the gate, and 0 volts on the source.

This sets up the ability to do a sector erase using word line decoding to select cells to be erased. The erase disturbance condition for unselected cells within a segment results in -8 volts on the drain, 0 volts on the gate, and -8 volts on the source. This is well within the tolerances of the cells to withstand these potentials without causing significant disturbance of the charge in the cell.

Similarly, the program disturbance conditions, for cells which share the same bit line in the same segment are 6 volts on the drain, 0 volts on the gate (or optionally 1 volt), and 0 volts or floating on the source. There is no gate to drain drive in this condition and it does not disturb the cell significantly.

For cells which share the same word line but not the same bit line or an addressed cell which is to remain in a high condition, the disturbance condition is 0 volts on the drain, -8 volts on the gate, and 0 volts or floating on the source. Again, this condition does not result in significant deterioration of the charge in the unselected cells.

In an alternative, hot electron injection may be used for charging up the floating gate by applying high positive voltages to the gate and drain, and a low voltage to the source.

Referring to Fig. 8, the page program bit latch/verify block 190 includes program verify circuitry which involves resetting on a bit by bit basis, the data in the page buffer that passes verify.

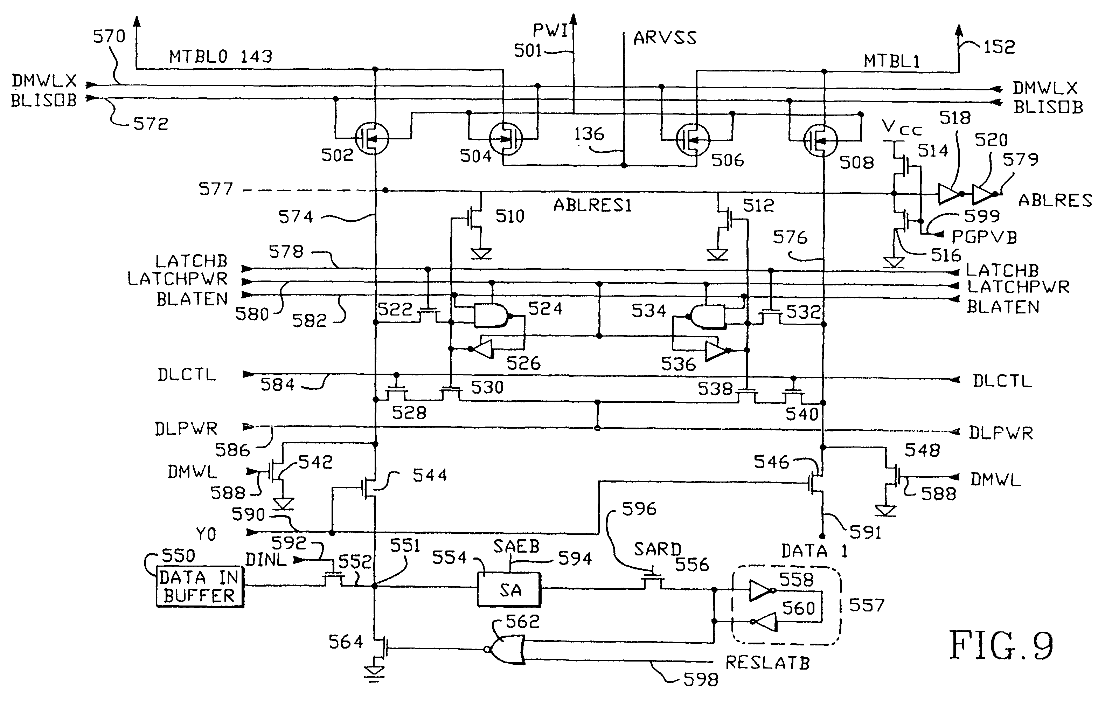

Fig. 9 is a schematic diagram of a section of the page program and automatic verify circuitry for two bit lines MTBL0 143 and MTBL1 152. Metal line 143 (MTBL0) of Fig. 9 corresponds to metal line 143 (MTBL0) of Fig. 7. Metal line 152 (MTBL1) corresponds to metal line 152 (MTBL1) of Fig. 7. Array virtual ground 136 (ARVSS) of Fig. 9 corresponds to the array virtual ground 136 (ARVSS) of Fig. 7. The signal PWI on line 501 is coupled to the p-well of transistors 502, 504, 506, and 508. Each pair of bitlines in the array has a similar structure coupled to it.

Referring to Fig. 9, the drain of transistor 502 and the drain of transistor 504 are coupled to the metal line 143 (MTBL0). The drain of transistor 506 and the drain of transistor 508 are coupled to the metal line 152 (MTBL1). The source of transistor of 504 and the source of transistor of 506 are coupled to the array virtual ground 136 (ARVSS). Signal DMWLX on line 570 is coupled to gate of transistor 504 and gate of transistor 506. When signal DMWLX on line 570 is active, the array virtual ground line 136 (ARVSS) is coupled to the metal line 143 (MTBL0) and the metal line 152 (MTBL1) via transistor 504 and transistor 506, respectively.

Data I/O line 574 is coupled to the source of transistor 502. Data I/O line 576 is coupled to the source of transistor 508. Signal BLISOB on line 572 is coupled to the gate transistor 502 and the gate of transistor 508. When signal BLISOB is high, metal line 143 is coupled to data I/O line 574 via transistor 502, and metal line 152 is coupled to data I/O line 576 via transistor 508.

Data I/O line 574 is coupled to the drain of transistor 542. The source of transistor 542 is coupled to ground, and the gate of transistor 542 is coupled to signal DMWL on line 588. The data I/O line 574 is pulled down when the signal DMWL is high.

Data I/O line 574 is further coupled to the drain of column select transistor 544. The source of transistor 544 is coupled to node 551. The gate of transistor 544 is coupled to signal Y0 on line 590.

A data in buffer 550 is coupled to the source of pass gate 552. The drain of pass gate 552 is coupled to node 551. Pass gate 552 is controlled by signal DINL on line 592.

Sense amp 554 is also coupled to node 551. Sense amp 554 is controlled by signal SAEB on line 594. The output of sense amp 554 is coupled to the drain of pass gate 556. The source of pass gate 556 is coupled to latch circuit 557. Pass gate 556 is controlled by signal SARD on line 596.

The latch circuit includes inverters 558 and 560. The input of inverter 558 is coupled to the source of pass gate 556. The output of inverter 558 is coupled to the input of inverter of 560, and the output of inverter 560 is coupled to the source of pass gate 556. The output of latch circuit 557 is also coupled to a first input to NOR gate 562. A second input to NOR gate 562 is coupled to signal RESLATB on line 598. The output of NOR gate 562 is coupled to the gate of transistor 564. The drain of transistor 564 is coupled to node 551, and the source is coupled to ground.

Data I/O line 576 which is coupled through transistor 508 to bit line 152 is connected in a similar manner. Thus, line 576 is coupled to the drain of transistor 548. The source of transistor 548 is coupled to ground, and the gate is coupled to signal DMWL on line 588. The drain of transistor 546 is also coupled to data I/O line 576. Signal Y0 is coupled to the gate of transistor of 546. The source of transistor 546 is coupled to node 591 which corresponds to node 551 for the other side. For simplicity, a corresponding set of DIN buffer 550, sense amp 554, latch circuit 557 and associated circuits coupled to node DATA 1 591 are not shown. In operation, circuits similar to DIN buffer 550, pass gate 552, sense amp 554, pass gate 556, latch circuit 557, NOR gate 562, and transistor 564 are similarly configured and coupled to node DATA 1 591.

Each data I/O line 574, 576 has a bit latch/verify logic circuit coupled to it, comprised generally of the NAND gate 524 and inverter 526 for data I/O line 574, and of NAND gate 534 and inverter 536 for data line I/O 576. For data I/O line 574, the drain of pass gate 522 is coupled to data I/O line 574, and the source of pass gate 522 is coupled to a first input of NAND gate 524. A second input to NAND gate 524 is coupled to signal BLATEN on line 582. The output of NAND gate 524 is coupled to the input of inverter 526. The input power for NAND gate 524 and inverter 526 is coupled to signal LATCHPWR on line 580. Signal LATCHB on line 578 is coupled to the gate of pass gate 522. The output of inverter 526 is coupled to the first input of NAND gate 524, the gate of transistor 510, and the gate of transistor 530. The drain of transistor 510 is coupled to signal ABLRES1 on line 577. The source of transistor 510 is coupled to ground. The drain of transistor 530 is coupled to signal DLPWR on line 586. The source of transistor 530 is coupled to the drain of transistor 528. The gate of transistor 528 is coupled to signal DLCTL on line 584, and the source of transistor 528 is coupled to data I/O line 574.

The data = 1 state latched in latch circuitry 524 and 526 pulls down signal ABLRES 1 on line 577. The logic high level enables transistor 510 which causes a logic low level on line 577. When transistor 510 is enabled, line 577 is coupled to ground which causes signal ABLRES 1 to a logic low level. Transistors 514 and 516 comprise an inverter, which, together with transistors 510 and 512, provides a NOR logic function. Transistor 514 is a p-channel transistor with the source coupled to Vcc and the drain coupled to the drain of n-channel transistor 516. Line 577 is coupled to the drains of transistors 514 and 516. The source of n-channel transistor 516 is coupled to ground, and the gates of transistors 514 and 516 are coupled to signal PGPVB on line 599. Inverters 518 and 520 are coupled in series. Line 577 provides the input to inverter 518. The output of inverter 518 provides the input of inverter 520, and the output of inverter 520 provides signal ABLRES on line 579. Thus, whenever latch circuitry 524 and 526 stores a logic high level, signal ABLRES is a logic low level. Transistor 514 provides a pull-up to line 577 which can be driven to a logic low level by enabling either transistor 510 or transistor 512.

The purpose of transistor 516 is that during default state PGPVB on line 599 is "HIGH", and all the gates of transistors 510, 512... are low, so that if there is no transistor 516, ABLRES1 on line 577 is floating. Transistor 516 is added to help line 577 to pull low in this case. During active mode, which is program-verify period during page program mode, PGPVB on line 599 is active "LOW", transistor 516 is off and transistor 514 provides a pull-up to line 577.

A mirrored arrangement of circuits also controlled by signals LATCHB, LATCHPWR, BLATEN and DLCTL and are coupled to data I/O line 576. The drain of pass gate of 532 is coupled to data I/O line 576. The gate of pass gate 532 is coupled to signal LATCHB on line 578. The source of pass gate 532 is coupled to a first input to NAND gate 534. A second input to NAND gate 534 is coupled to signal BLATEN on line 582. The output of NAND gate 534 is coupled to the input of inverter 536. Signal LATCHPWR on line 580 provides input power to NAND gate 534 and inverter 536. The output of inverter of 536 is coupled to the first input of NAND gate 534. the gate of transistor of 512, and the gate of transistor 538. Signal DLPWR on line 586 is coupled to the drain of transistor 538. The source of transistor 538 is coupled to the drain of transistor 540. The gate of transistor of 540 is coupled to signal DLCTL on line 584, and the source of transistor 540 is coupled to data I/O line 576. The source of transistor 512 is coupled to ground and the drain of transistor 512 is coupled to line 577.

In operation, the page program and automatic verify circuit of the flash EEPROM array as shown in Fig. 9 executes the page program and program verify in a series of stages. The stages can be generalized as a (1) data loading stage; (2) data program stage; (3) read the array data stage; (4) reset bit latch stage; and (5) retry stage. The operation of the page program and automatic verify of the flash EEPROM array is described with reference to data I/O line 574. Page program and automatic verify are similarly performed using data I/O line 576 that is coupled to another memory cell. Furthermore, the page program and automatic verify circuit includes similar circuitry for all data I/O lines needed to program a page of memory cells in the flash EEPROM array.

In the data loading stage, signal LATCHPWR on line 580, signal LATCHB on line 578, and signal BLATEN on line 582 are supplied with 5 volts to activate data latch circuitry 524 and 526 for operation. Signal LATCHPWR on line 580 supplies voltage to NAND gate 524 and inverter 526 for operation. Signal BLATEN on line 582 enables latch circuitry 524 and 526 to receive inputs. Signal LATCHB on line 578 enables pass gate 522 to couple data I/O line 574 with the first input of NAND gate 524. Signal BLISOB on line 572 is at a logic low level which disables transistor 502. Disabling transistor 502 isolates data I/O line 574 from the metal line 143 (MTBL0). Signal DLCTL on line 584 is at a logic low level which disables pass gate 528. Signal DLPWR is at a logic high level having a voltage of Vcc that is approximately 5 volts. Signal DMWL on line 588 is at a logic low which prevents transistor 542 from coupling data I/O line 574 to ground. Signal Y0 on line 590 is a logic high level which enables transistor 544 to conduct. Signal Y0 is a decoded signal which enables data I/O line 574 to access a corresponding one of 16 DIN buffers (e.g. buffer 550) during the data loading stage. Signal DINL on line 592 is a logic high which enable pass gate 552. Input data from DIN buffers 550 is transferred via pass gate 552 to data I/O line 574.

Once input data is transferred to data I/O line 574, the data from DIN buffer 550 is transferred to the first input of NAND gate 524. If data from DIN buffer 550 is a logic high level, the logic high level received at the first input of NAND gate 524 causes a logic low output. The logic low output of NAND gate 524 provides the input to inverter 526 which provides a logic high output. NAND gate 524 and inverter 526 comprise the bit latch circuitry 524 and 526 which latches the data received at the first input of NAND gate 524. The logic high level at the output of inverter 526 enables pass gate 530 and transfers signal DLPWR on line 586 to pass gate 528. However, during the data loading stage, signal DLCTL on line 584 is a logic low which disables pass gate 528 from conducting signal DLPWR to data I/O line 574.

In the other case, when data from DIN buffer 550 is a logic low level, the logic low level received at the first input of NAND gate 524 causes a logic high output. The logic high output of NAND gate 524 provides the input to inverter 526 which provides a logic low output that is stored in latch circuitry 524 and 526. The logic low at the output of inverter 526 disables pass gate 530 and the transfer of signal DLPWR on line 586 via pass gate 528 to data I/O line 574. Thus, the bit latch circuit of NAND gate 524 and inverter 526 stores either the logic high level or the logic low level of the input data which corresponds to the data transferred from DIN buffer 550.

The bit latches for up to the entire page of 1024 bits are loaded in 16 bit segments relying on the protocol outlined above to detect the last 16 bit segment in the block. Bit latches not loaded are set to zero. Once the input data from DIN buffers 550 is loaded into bit latch circuitry 524 and 526 after the data loading stage, a verify sequence is executed followed by the data write stage. The pre-writing verify loop (according to the sequence described below) prevents over programming cells into depletion such as if a user programs the page with the same data twice. A data write occurs when a logic high is stored in the latch circuitry 524 and 526. When a logic high level data = 1 state is received from DIN buffer 550, the logic high level is programmed to a cell of the flash EEPROM array during the data write stage. If a logic low level (data=0) is received from DIN buffer 550 and stored in latch circuitry 524 and 526, the data write stage does not program the memory cell of the flash EEPROM.

In the present example. a logic high level (data =1) is transferred from DIN buffer 550 and stored in bit latch circuitry 524 and 526. During the execution of the data write stage, signal LATCHB on line 578 is disabled. Signal LATCHB on line 578 is set to a logic low to disable inputs to latch circuitry 524 and 526. Signal LATCHPWR is set to a high voltage to provide power to latch circuitry 524 and 526. Signal BLATEN on line 582 is set to a high voltage level to enable the output of latch circuitry 524 and 526. Signal BLISOB on line 572 is set to a high voltage level to enable transistor 502. Transistor 502 couples data I/O line 574 to metal line 143. Signal DLCTL on line 584 is set to a high voltage level to enable pass gate 528. Signal DLPWR on line 586 is set to a high voltage. Signal Y0 on line 590 is a logic low level to disable transistor 544. Signal DINL is a logic low level which decouples input data from DIN buffer 550 from data I/O line 574. Signal SAEB is a logic low level to disable sense amp 554.

Once the control signals are properly initialized to perform the data program stage. signal DLPWR on line 586 is transferred to data I/O line 574. Signal DLPWR provides programming power to program a memory cell in the flash EEPROM array. Thus, if latch circuitry 524 and 526 is latched with a data = 1 state, pass gate 530 is enabled to permit signal DLPWR to pass through pass gate 528. Signal BLISOB on line 572 enables transistor 502 and couples signal DLPWR to the metal line 143 (MTBL0).

Referring to Fig. 7, enabling signal BLTR1 on line 141 or BLTR0 on line 142 couples a column of cells to the metal line 143 and provides the programming voltage from signal DLPWR to program a particular memory cell 125 or 129 on the word line which is changed to -8 volts. For instance, if BLTR 1 on line 141 is selected and word line WL 1 is selected, the programming voltage from signal DLPWR is directed to memory cell 125.

After the data from latch circuitry 524 and 526 is programmed to the memory cell, the circuitry is ready to verify automatically that the data was properly programmed in the data write stage. This involves a five step sequence (A through E) for deciding whether to reset the bit latch as follows:

## Step A

READ the real data from the non-volatile bit through the associated sense amp (all 16 sense amps are activated at the same time, i.e. 16 bits are read at the same time). The sensing result is stored in latch 557 of Fig. 9. For example. in Fig. 9, to verify a selected cell from a specified wordline, BLISOB (572) must be high (ON), selected Y (544, 546 and 14 more of such devices) is on. sense amp (SA) 554 is activated (and 15 other SA), SARD (596) is high to allow the sensing result pass to the latch (557) and LATCHB (578), DLCTL (584) are at low voltage (OFF) so that during this READ step, the bit latch consisting of 524 and 526 will not be disturbed. The selected cell threshold voltage is sensed by the SA (554) via data line 574 and then stored in latch 557, after a certain amount of time which is long enough for the SA (554) to do the sensing. If after programming, the cell's threshold voltage (VT) is low enough (to the point that the SA 554 can tell that the cell is at low VT state) then the output of the inverter (560, or input of 558) will reflect a low level, SARD (596) is off and then SA (544) is disabled. The low level is stored in latch (557), no matter what read happens during the next 4 steps in sequence until the new locations need to be read again. If after programming, the selected cell VT is still read high, then the output of inverter 560 is at high level, i.e. a logic high level is latched in latch 557. Note that RESLATB (598) is HIGH in this step so that whether latch 557 latched high or low will not affect device (564) because device 564 is OFF anyway.

## Step B

DISCHARGE DATA LINES (all including selected and deselected) The purpose of this step will be explained in STEP D). The way of discharging the data line 574 is by activating DMWL (588) to high turning on transistors 542 and 548, LATCHB at low, DLCTL at low, with all sense amps disabled, 564 and 552 are off. Transistor 542 discharges charge stored in data line 574. BLISOB (572) is at low level to isolate the long metal-bit-line (MTBL0) from the data line (574) so that the discharge sequence can be achieved faster.

## Step C

PRE-CHARGE DATA LINES (selectively. according to the associated bit latch) The purpose of this step will be explained in step D.) During this step, DMWL is at low level, BLISOB is still at low level, whether the selected 16 data lines of the same word and other deselected data lines should be precharged to a high voltage level or not is decided by the data which is stored in the bit latch. For example, in Fig. 9, during this step LATCHB (578) is still off, DLCTL (584) is switched from low to high, and data line 574 is precharged to a high level by connecting DLPWR (a $V_{CC}$ level power source for this instance) to the data line (574) via devices 530 and 528 if the output of inverter 526 (which is the gate of 530) is latched at HIGH level. Otherwise DLPWR cannot precharge data line 574 to a high level and the data line 574 should be still at a low voltage level due to step B.

## Step D

RESET BIT LATCH OR NOT? During this step LATCHB (578) is switched from low level to a high level, and RESLATB (598) switches from high to low in order to reset bit latch (which consists of inverter 524 and 526) by turning on 564, if the output of inverter 560 is (latched) low (from step A). Since the selected cell is at low VT already, the bit latch content shall be reset so that for the next programming, high voltage pulse sequence, the cell which is at low VT shall not be programmed to low VT again. There is a chance that the bit latch had been reset from a previous verify loop step D) or was at reset state even before the first programming sequence. In these cases, the subsequent reset bit latch step is of no effect to the bit latch for the former case; and for the latter case whether the selected cell is at high VT or not will not affect the bit latch because that if the cell is at high VT, there is no resetting the bit latch (564 is OFF, from Steps A and D) and bit latch was at reset state. If the cell was at low VT, then resetting the bit latch again makes no difference to the contents of the bit latch. There is no comparison circuit needed in this implementation.

Note that LATCHB is a global signal to all the bit latches in the FLASH EEPROM design and the high level at the gates of 522, 532 ... results in all bit latches talking to the associated data lines which means that the node of the output of inverter 526 will encounter a charge sharing with the associated data line (574, for example). The driving capability of inverter 526 is designed to be a weak device in order that a proper data can be set (to fight against inverter 526) into the bit latch. So when LATCHB (578) is HIGH, weak inverter (526) suffers a charge sharing issues which results in the uncertainty of the integrity of the bit latch.

The purpose of steps B) and C) is to put the proper voltage level at the data lines before getting into step D), i.e. before LATCHB (578) switches from low to high to avoid any "charge sharing issues", even though the circuitry can be designed as mentioned above to ensure proper operation without them. During step B), all data lines are discharged to low level and then at step C) only those data lines whose associated bit latches "stored" high level will be precharged to a high level. Thus steps B) and C) are optional steps inserted here for safety in the design.

Step E

DISCHARGE ALL DATA LINES AGAIN. At this moment, the program-verify activity is pretty much done, before moving into the next word for programming-verifying (or more precisely, to change the new word and repeat from step A) to step D)),the logic control will remove residue charges from all the data lines and switch to new word. For example, during this step, LATCHB (578) is at LOW level, RESLATB (598) is at HIGH level, DMWL (588) is at HIGH level and BLISOB (572) is at HIGH level.

Thus, the page program and automatic verify circuit of Fig. 9 provides the unique feature of automatically verifying a memory cell that is programmed. Latch circuitry 524 and 526 stores the input data received from DIN buffer 550. The stored data in latch circuitry 524 and 526 controls ABLRES 1 which is set to a logic low level if there is one or more than one of the cells which need to be programmed. Signal ABLRES 1 remains a logic low level until all the page memory cells are verified during the program verify sequence which resets all latches (524 and 526) to a logic low level and resets signal ABLRES1 to a logic high level indicating a properly programmed memory cell. The program verify sequence is automatic.

Signal PGPVB on line 599 is a logic low level to supply a charge to line 577 during automatic verify sequence. When latch circuitry 526 and 524 is reset, transistor 510 is disabled and the charge on line 577 is no longer discharged to ground. Signal ABLRES1 on line 577 becomes a logic high level. The logic high level provides an input to inverter 518 which produces an output that provides an input to inverter 520 which provides the logic high level output of signal ABLRES on line 579. The logic high level of signal ABLRES on line 579 provides a page programmed verify signal signifying the page of memory cells has passed program verify.

Each memory cell within a page of memory cells in the array is able to activate a transistor 510 to cause signal ABLRES 1 on line 577 to a low level. Thus, any memory cell that does not pass program verify within a page of memory cells in the array can cause the output ABLRES to be a logic low level. The logic low level of ABLRES on line 579 signals that at least one memory cell within the page of memory cells in the array is not properly programmed and verified. Thus, any memory cell not properly verified can cause signal ABLRES on line 579 to be a logic low level. When all memory cells are properly programmed and verified, signal ABLRES on line 579 is a logic high level.

In operation, unsuccessfully programmed memory cells are reprogrammed and reverified until signal ABLRES becomes a logic high level. The number of retries are limited to prevent looping of the programming sequence if a page repeatedly fails program verification.

Fig. 10 provides a flow chart illustrating the program flow for the flash EEPROM circuit of Fig. 9. The process begins by erasing the sector (e.g., sector 170-1) into which data is to be programmed (block 700). After erasing the sector. an erase verify operation is executed (block 701). Next, the page number, either 0 or 1, and the segment number, 1-8, is set by the host processor in response to the input address (block 702).

After setting the page number and segment number, the page buffer is loaded with a block including from one byte up to a full page (block 703). The page buffer may be loaded with an entire page of data. or a single byte of data, as suits a particular program operation. The end of the load portion of the autoprogram cycle is indicated by the pattern match described above. Next, a verify operation is executed, in case the user does not pre-erase, or tries to reprogram the same data, to determine which cells need programming (block 704). After loading the page buffer, the program potentials are applied to the segment being programmed (block 705). After the program page operation, a verify operation is executed in which the page is verified. In the verify operation. the programmed page is read and each corresponding read bit of data is stored in a sense amp data latch (block 715).

The page bits which pass verify are reset (block 722). Next, the algorithm determines whether all page bits are turned off in the page buffer (block 723). If they are not all off, then the algorithm determines whether a maximum number of retries has been made (block 710), and if not, loops to block 705 to program the page again, such that the failed bits are reprogrammed. The bits which pass are not reprogrammed because the corresponding bits in the page buffer were reset to 0 during the verify operation. If the maximum number of retries has been made at block 710, then the algorithm is done (block 730), signaling an unsuccessful operation.

If at block 723, all page bits were off, then the algorithm determines whether the sector has been finished, that is, whether both pages of the sector are to be written and both are completed (block 725). This is a CPU determined parameter. If the sector is not finished, then the algorithm loops to block 702 and updates the appropriate one of the page number or segment number. If the sector has been finished at block 725, then the algorithm is done (block 730).

Accordingly, a new flash EEPROM array architecture with an autoprogram function which detects the end of a load cycle in response to transistors in the address and/or data signals applied to the memory, has been provided. The architecture provides for a very dense core array obtained by unique cell layouts, where two adjacent local drain bit lines share one common source bit line. Also, the layout has been optimized to allow use of a single metal line for every two columns of cells in the array. Further, the layout is further reduced by shared word lines. so that the word line driver pitch does not impact the size of the main array. Sector erase is feasible using segmentable architecture of the present invention. Also, the page program and automatic verify circuitry provides efficient and accurate programming of the memory cells. Thus. a high performance, reliable flash memory array can be achieved using these technologies.

An n-channel embodiment of the flash EEPROM array has been disclosed. Those skilled in the art will recognize that p-channel equivalent circuits can be implemented using techniques known in the art. Furthermore, the architecture has been designed with respect to flash EEPROM cells. Many aspects of the architecture may be adapted to a variety of memory circuit arrays.

In conclusion, the present invention provides a page programmed flash EEPROM device, in which the length of a block of data being stored in a given page program operation can be arbitrarily defined, and which does not require the 100 microsecond pulse to indicate the end of the program load segment of an automatic programming cycle. The system is particularly suitable for high density integrated circuit memories, storing 16 megabits or more of data in a floating gate memory integrated circuit.

The foregoing description of a preferred embodiment of the invention has been presented for purposes of illustration and description. It is not intended to be exhaustive or to limit the invention to the precise forms disclosed. Obviously, many modifications and variations will be apparent to practitioners skilled in this art. It is intended that the scope of the invention be defined by the following claims and their equivalents.

**Claims**

1. A integrated circuit memory, comprising:

   an array (10) of storage elements;
   input/output circuitry (25, 29, 31), having inputs to receive addresses and data and coupled to the array, to read and store data segments in the array in response to addresses and data on the inputs; and
   command logic (37, 35), coupled to the input/output circuitry, operable to execute a process to store a block of data in response to a sequence of addresses and data segments received at the input/output circuitry, including logic (37) to monitor the sequence to detect a pattern indicating an end of the block of data, the pattern including at least one of addresses and data received at the input/output circuitry.

2. The memory of claim 1, wherein the pattern includes consecutive matching addresses, and the command logic includes a store for addresses and a comparator to match a received address with an address in the store.

3. The memory of claim 1, wherein the pattern includes consecutive matching addresses and data segments, and the command logic includes a store for addresses and data segments and a comparator to match a received address and data segment with an address and data segment in the store.

4. The memory of claim 1, wherein locations for data to be stored are identified by addresses within an address field, and the pattern includes a command address outside the address field, and the command logic includes a store for the command address and a comparator to match a received address with the command address in the store.

5. The memory of claim 1, wherein locations for data to be stored are identified by addresses within an address field, the addresses having a high order segment and a low order segment, and the pattern includes a start command supplied in the high order segment of the address comprising a bit pattern outside the address field, supplied after loading the block of data.

6. The memory of claim 1, wherein locations for data to be stored are identified by addresses within an address field, the addresses having a high order segment and a low order segment, and the pattern includes a load command supplied in the high order segment of the address comprising a bit pattern outside the address field, supplied during loading the block of data.

7. The memory of claim 6, wherein the pattern includes changing the high order segment of the received address from the load command to the value within the address field while loading a last data segment in the sequence.

8. The memory of claim 1, wherein the array comprises floating gate memory cells.

9. The memory of claim 1, including a state machine (19), responsive to the command logic, for automatically programming and verifying programming of the block of data after the last segment in the block is detected.

10. The memory of claim 1, wherein the array comprises floating gate memory cells, and the input/output circuitry includes a state machine (19), responsive to the command logic, for automatically programming and verifying programming of the block of data after the last segment in the block is detected.

11. The memory of claim 10, wherein the input/output circuitry includes resources coupled with the state machine for applying potentials to the floating gate cells which cause Fowler-Nordheim tunneling in cells to be programmed.

12. The memory of claim 10, wherein the input/output circuitry includes resources coupled with the state machine for applying potentials to the floating gate cells which cause hot electron injection in cells to be programmed.

13. The memory of claim 1, wherein the input/output circuitry is operable to receive a control signal establishing timing for the sequence of addresses and data segments, the command logic including logic to detect a pulse in the control signal having a characteristic pulse width indicating that the block is loaded, and including a state machine, responsive to the command logic, for automatically programming and verifying programming of the block of data after the last segment in the block or the pulse is detected.

14. The memory of claim 1, wherein the pattern comprises an address transition in the sequence.

15. The memory of claim 1, wherein the memory is a floating gate memory circuit on a semiconductor substrate, and the array (10) includes at least M rows and N columns (120, 135, 150, 151) of floating gate cells, the memory further comprising:

M word lines (WLO...WL63, WLO'...WL63'), each coupled to the floating gate cells in one of the M rows of floating gate cells;
a plurality of bit lines (121,123), each coupled to the floating gate cells in at least one of the N columns of floating gate cells;
a page buffer (31) within the input/output circuitry for storing the block of data and supplying the block of data to the N columns of floating gate cells;
write control circuitry (19, 14), coupled to the command logic, the page buffer and the M word lines, which after detection of the pattern indicating the end of the block of data, is operable to supply programming voltages to a selected word line for programming input data to a row of floating gate cells accessed by the selected word line in response to the input data stored in the page buffer; and
program verify circuitry, coupled to the page buffer, operable to verify that floating gate cells are programmed with the block of data in the page buffer.

16. The memory of claim 15, wherein the page buffer includes a plurality of bit latches coupled to corresponding ones of the plurality of bit lines, and the program verify circuitry includes logic coupled to the page buffer, and to the bit lines, for resetting bit latches to a first binary value when stored data in a floating gate cell on a corresponding bit line matches a second binary value.

17. The memory of claim 15, wherein:

a row of N columns of floating gate cells include a first page and a second page; and
the page buffer is operable to supply input data to a page of floating gate cells.

18. The memory of claim 16, wherein the program verify circuitry includes logic responsive to stored data from the floating gate cells and to data in the page buffer to provide the program verified signal when all programmed floating gate cells pass program verify.

19. The memory of claim 16, wherein the program verify circuitry is operable to generate a program verified signal when all bit latches store the first binary value.

20. The memory of claim 19, wherein the write control circuitry is operable to apply a word line program potential to a word line coupled to a selected set of floating gate cells, and a bit line program potential to bit lines coupled to bit latches storing the second binary value.

21. The memory of claim 15, wherein the pattern includes consecutive matching addresses, and including a store, coupled to the input/output circuitry, to hold addresses and a comparator, coupled to the input/output circuitry, to match a currently received address with a previously received address held in the store.

22. The memory of claim 15, wherein the pattern includes consecutive matching addresses and data segments, and including a store, coupled with the input/output circuitry, to hold addresses and data segments and a comparator, coupled to the input/output circuitry, to match a currently received address and data segment with a previously received address and data segment held in the store.

23. The memory of claim 15, wherein locations in the page buffer are identified by addresses within an address field, and the pattern includes a command address outside the address field, and including a store for the command address and a comparator, coupled with the input/output circuitry. to match a received address with the command address in the store.

24. The memory of claim 15, wherein locations for data to be stored are identified by addresses within an address field, the addresses having a page address segment and a page buffer address segment, and the pattern includes a start command supplied in the page address segment of the address comprising a bit pattern outside the address field, supplied after loading the block of data.

25. The memory of claim 15 wherein locations for data to be stored are identified by addresses within an address field, the addresses having a page address segment and a page buffer address segment, and the pattern includes a load command supplied in the page address segment of the address comprising a bit pattern outside the address field, supplied during loading the block of data.

26. The memory of claim 25, wherein the pattern includes changing the page address segment of the received address from the load command to the value within the address field while loading a last data segment in the sequence.

27. The memory of claim 15, wherein the input/output circuitry is operable to receive a control signal establishing timing for the sequence of addresses and data segments, the command logic including logic to detect a pulse in the control signal having a characteristic pulse width indicating that the block is loaded, and wherein the write control circuitry is operable to apply program voltages in response to either of detection of the last segment in the block or of the pulse.

28. The memory of claim 15, wherein the program voltages applied to the floating gate cells cause Fowler-Nordheim tunneling in cells to be programmed.

29. The memory of claim 15, wherein the program voltages applied to the floating gate cells cause hot electron injection in cells to be programmed.

30. The memory of claim 15, wherein the pattern comprises an address transition in the sequence.

31. A method of storing a block of data in an array (10) of storage elements of an integrated circuit memory, comprising the steps of:

   executing a process to store the block of data in response to a stream of
   addresses and segments of data received by input/output circuitry (25, 29, 31) coupled to the array;
   during the process, monitoring the stream of addresses and segments of data to detect a pattern ($A_x$, $A_x$; $D_x$, $D_x$) in the stream which signals an end of the block of data, the pattern including at least one of addresses and data received at the input/output circuitry.

32. The method as claimed in claim 31, wherein the integrated circuit memory is a floating gate memory device and the block of data consists of less than or equal to a page in the floating gate memory device, the method further comprising:

   supplying (60, 61, 62) a command which indicates an automatic program operation to the memory device;
   after supplying the command, supplying the stream of addresses (A0, A1 ...) and segments of data (D0, D1...), and storing the supplied segments in a page buffer (31);
   after detection of the pattern, executing a program operation (63) to store the block of data from the page buffer.

33. The method of claim 32, wherein the pattern includes two matching addresses in sequence in the stream.

34. The method of claim 32, wherein the pattern includes a sequence of two matching addresses and segments of data in the system.

35. The method of claim 32, wherein the pattern includes an address in the stream matching a pre-specified command address.

36. The method of claim 32, wherein locations for data to be stored are identified by addresses within an address field, the addresses having a page address segment and a page buffer address segment, and the pattern includes a start command supplied in the page address segment of the address comprising a bit pattern outside the address field, supplied after loading the block of data.

37. The method of claim 32, wherein locations for data to be stored are identified by addresses within an address field, the addresses having a page address segment and a page buffer address segment, and the pattern includes a load command supplied in the page address segment of the address comprising a bit pattern outside the address field, supplied during loading the block of data, and a change in the page address segment field to a value within the address field.

38. The method of claim 37, wherein the pattern includes changing the page address segment of the received address from the load command to the value within the address field while loading a last data segment in the sequence.

**39.** The method of claim 32, wherein the step of storing includes storing the block of data in parallel.

**40.** The method of claim 32, including automatically verifying the storing of the block of data. and retrying the storing if an error is found.

**41.** The method of claim 32, wherein the pattern comprises an address transition in the stream.


**Patentansprüche**

**1.** Integrierter Speicherschaltkreis mit:

einem Array (10) aus Speicherelementen, einer Eingabe-/Ausgabeschaltung (25, 29, 31), welche Eingänge hat, um Adressen und Daten aufzunehmen, und welche mit dem Array verbunden ist, um in Reaktion auf Adressen und Daten an den Eingängen Datensegmente in dem Array zu lesen und in diese zu speichern, einer Befehlslogik (37, 35), welche mit der Eingabe-/Ausgabeschaltung verbunden ist und welche derart betreibbar ist, daß sie einen Prozeß zum Speichern eines Blockes von Daten in Reaktion auf eine Sequenz von Adressen und Datensegmenten, die an der Eingabe-/Ausgabeschaltung empfangen werden, auszuführen, einschließlich einer Logik (37), um die Sequenz zu überwachen, um ein Muster zu erfassen, welches ein Ende des Datenblokkes anzeigt, wobei das Muster zumindest eine bzw. einen der an der Eingabe-/Ausgabeschaltung empfangenen Adressen und/oder Datenwerte enthält.

**2.** Speicher nach Anspruch 1, wobei das Muster aufeinanderfolgende zusammenpassende Adressen enthält und die Befehlslogik einen Speicher für Adressen enthält sowie einen Vergleicher, um die empfangene Adresse mit einer Adresse in dem Speicher abzugleichen.

**3.** Speicher nach Anspruch 1, wobei das Muster aufeinanderfolgende übereinstimmende Adressen und Datensegmente enthält und wobei die Befehlslogik einen Speicher für Adressen und Datensegmente sowie einen Komparator enthält, um eine empfangene Adresse und ein Datensegment mit einer Adresse und einem Datensegment in dem Speicher abzugleichen.

**4.** Speicher nach Anspruch 1, wobei Positionen für zu speichernde Daten durch Adressen innerhalb eines Adreßfeldes gekennzeichnet werden und wobei das Muster eine Befehlsadresse außerhalb des Adreßfeldes enthält, und wobei die Befehlslogik einen Speicher für die Befehlsadresse sowie einen Vergleicher enthält, um die empfangene Adresse mit der Befehlsadresse in dem Speicher abzugleichen.

**5.** Speicher nach Anspruch 1, wobei Positionen für zu speichernde Daten durch Adressen innerhalb eines Adreßfeldes gekennzeichnet werden, wobei die Adressen ein Segment höherer Ordnung und ein Segment niedrigerer Ordnung haben und wobei das Muster einen Startbefehl enthält, der in dem Adreßsegment höherer Ordnung zugeführt wird, welcher ein Bitmuster außerhalb des Adreßfeldes aufweist, welches nach dem Laden des Datenblokkes zugeführt wird.

**6.** Speicher nach Anspruch 1, wobei Positionen für zu speichernde Daten durch Adressen innerhalb eines Adreßfeldes gekennzeichnet werden, wobei die Adressen ein Segment höherer Ordnung und ein Segment niedrigerer Ordnung haben, und wobei das Muster einen Ladebefehl enthält, welcher in dem Segment der Adresse höherer Ordnung zugeführt wird, mit einem Bitmuster außerhalb des Adreßfeldes, welches während des Ladens des Datenblockes zugeführt wird.

**7.** Speicher nach Anspruch 6, wobei das Muster das Verändern des Segments höherer Ordnung der empfangenen Adresse von dem Ladebefehl auf den Wert innerhalb des Adreßfeldes umfaßt, während ein letztes Datensegment in der Sequenz geladen wird.

**8.** Speicher nach Anspruch 1, wobei das Array Speicherzellen mit potentialfreiem Gate aufweist.

**9.** Speicher nach Anspruch 1, einschließlich einer Zustandsmaschine (19), die auf die Befehlslogik reagiert, um den Datenblock automatisch zu programmieren und das Programmieren zu verifizieren, nachdem das letzte Segment in dem Block erfaßt worden ist.

**10.** Speicher nach Anspruch 1, wobei das Array Speicherzellen mit potentialfreien Gates aufweist und wobei die Eingabe-/Ausgabeschaltung eine Zustandsmaschine (19) enthält, die auf die Befehlslogik reagiert, um den Block von Daten automatisch zu programmieren und das Programmieren zu verifizieren, nachdem das letzte Segment in dem Block erfaßt worden ist.

**11.** Speicher nach Anspruch 10, wobei die Eingabe-/Ausgabeschaltung Ressourcen enthält, die mit der Zustandsmaschine verbunden sind, um an den potentialfreien Gatezellen Potentiale anzulegen, welche in den zu programmierenden Zellen ein Fowler-Nordheim-Tunneln verursachen.

12. Speicher nach Anspruch 10, wobei die Eingabe-/Ausgabeschaltung Ressourcen enthält, die mit der Zustandsmaschine verbunden sind, um an den Zellen mit potentialfreiem Gate Potentiale anzulegen, welche an den zu programmierenden Zellen ein Injizieren heißer Elektronen verursachen.

13. Speicher nach Anspruch 1, wobei die Eingabe-/Ausgabeschaltung so betreibbar ist, daß sie ein Steuersignal empfängt, welches einen Zeittakt für die Folge von Adressen und Datensegmenten bereitstellt, wobei die Befehlslogik eine Logik umfaßt, welche einen Impuls in dem Steuersignal erfaßt, der eine charakteristische Pulsbreite hat, welche anzeigt, daß der Block geladen ist, und eine Zustandsmaschine umfaßt, die auf die Befehlslogik reagiert, um den Block von Daten automatisch zu programmieren und das Programmieren zu verifizieren, nachdem das letzte Segment in dem Block des Impulses erfaßt worden ist.

14. Speicher nach Anspruch 1, wobei das Muster einen Adreßübergang in der Sequenz umfaßt.

15. Speicher nach Anspruch 1, wobei der Speicher eine Speicherschaltung mit potentialfreien Gates auf einem Halbleitersubstrat ist und wobei das Array (10) zumindest M Reihen und N Spalten (120, 135, 150, 151) aus Zellen mit potentialfreiem Gate aufweist, wobei der Speicher weiterhin aufweist:

M Wortleitungen (WLO...WL63, WLO'...WL63'), die jeweils mit den Zellen mit potentialfreiem Gate in einer der M Reihen von Zellen mit potentialfreiem Gate verbunden sind, eine Mehrzahl von Bitleitungen (121, 123), die jeweils mit den Zellen mit potentialfreiem Gate in zumindest einer der N Spalten von Zellen mit potentialfreiem Gate verbunden sind, einen Seitenpuffer (31) in der Eingabe-/Ausgabeschaltung, um den Datenblock zu speichern und den Datenblock den N Spalten aus Zellen mit potentialfreiem Gate zuzuführen, eine Schreibsteuerschaltung (19, 14), die mit der Befehlslogik, dem Seitenpuffer und den M Wortleitungen verbunden ist, welche nach der Erfassung des Musters das Ende des Blockes von Daten anzeigt, und welche so betreibbar ist, daß sie Programmierspannungen an eine ausgewählte Wortleitung zuführt, um Eingangsdaten in eine Reihe aus Zellen mit potentialfreiem Gate zu programmieren, auf welche durch die ausgewählte Wortleitung in Reaktion auf die in dem Seitenpuffer gespeicherten Eingangsdaten zugegriffen wird, und eine Programmierverifizierungsschaltung, welche mit dem Seitenpuffer verbunden ist, und welche so betreibbar ist, daß sie verifiziert, daß Zellen mit potentialfreiem Gate mit dem Datenblock in dem Seitenpuffer programmiert sind.

16. Speicher nach Anspruch 15, wobei der Seitenpuffer eine Mehrzahl von Bitschaltern aufweist, die mit entsprechenden aus der Mehrzahl von Bitleitungen verbunden sind, und wobei die Programmierverifizierungsschaltung eine Logik enthält, die mit dem Seitenpuffer und mit den Bitleitungen verbunden ist, um Bitschalter auf einen ersten binären Wert zurückzusetzen, wenn gespeicherte Daten in einer Zelle mit potentialfreiem Gate auf einer entsprechenden Bitleitung mit einem zweiten binären Wert übereinstimmen.

17. Speicher nach Anspruch 15, wobei
eine Reihe von N Spalten aus Zellen mit potentialfreiem Gate eine erste Seite und eine zweite Seite enthalten, und
der Seitenpuffer so betreibbar ist, daß er Eingangsdaten an eine Seite von Zellen mit potentialfreiem Gate zuführt.

18. Speicher nach Anspruch 16, wobei die Programmierverifizierungsschaltung eine Logik enthält, die auf gespeicherte Daten aus den Zellen mit potentialfreiem Gate und auf Daten in dem Seitenpuffer reagiert, um das Signal der Verifizierung der Programmierung bereitzustellen, wenn alle programmierten Zellen mit potentialfreiem Gate die Verifizierung der Programmierung erfolgreich durchlaufen haben.

19. Speicher nach Anspruch 16, wobei die Programmierverifizierungsschaltung so betreibbar ist, daß sie ein Signal der Programmierverifizierung erzeugt, wenn alle Bitschalter den ersten binären Wert speichern.

20. Speicher nach Anspruch 19, wobei die Schreibsteuerschaltung so betreibbar ist, daß sie ein Wortleitungsprogrammierpotential an eine Wortleitung anlegt, welche mit einem ausgewählten Satz von Zellen mit potentialfreiem Gate verbunden ist, und ein Bitleitungsprogrammierpotential an Bitleitungen anlegt, die mit Bitschaltern verbunden sind, welche den zweiten binären Wert speichern.

21. Speicher nach Anspruch 15, wobei das Muster aufeinanderfolgende übereinstimmende Adressen enthält sowie einen Speicher enthält, der mit der Eingabe-/Ausgabeschaltung verbunden ist, um Adressen zu erhalten, und einen Komparator enthält, der mit der Eingabe-/Ausgabeschaltung verbunden ist, um eine aktuell empfangene Adresse gegen eine zuvor empfangene, in dem Speicher gehaltene Adresse abzugleichen.

22. Speicher nach Anspruch 15, wobei das Muster aufeinanderfolgende übereinstimmende Adressen und Datensegmente enthält und einen Speicher enthält, der mit der Eingabe-/Ausgabeschaltung verbunden ist, um Adressen und Datensegmente zu halten, und einen Vergleicher enthält, der mit der Eingabe-/Ausgabeschaltung verbunden ist, um eine aktuell empfangene Adresse und ein Datensegment mit einer zuvor empfangenen Adresse und einem Datensegment abzugleichen, die in dem Speicher gehalten werden.

23. Speicher nach Anspruch 15, wobei Positionen in dem Seitenpuffer durch Adressen innerhalb eines Adreßfeldes identifiziert werden und wobei das Muster eine Befehlsadresse außerhalb des Adreßfeldes enthält, und mit einem Speicher für die Befehlsadresse und mit einem Komparator, der mit der Eingabe-/Ausgabeschaltung verbunden ist, um eine empfangene Adresse mit der Befehlsadresse in dem Speicher abzugleichen.

24. Speicher nach Anspruch 15, wobei Positionen für Daten, die gespeichert werden sollen, durch Adressen innerhalb eines Adreßfeldes gekennzeichnet sind, wobei die Adressen ein Seitenadreßsegment und ein Seitenpufferadreßsegment haben und wobei das Muster einen Startbefehl enthält, der in dem Seitenadreßsegment der Adresse zugeführt wird mit einem Bitmuster außerhalb des Adreßfeldes, welches nach dem Laden des Blockes von Daten zugeführt wird.

25. Speicher nach Anspruch 15, wobei Positionen für zu speichernde Daten durch Adressen innerhalb eines Adreßfeldes gekennzeichnet sind, wobei die Adressen ein Seitenadreßsegment und ein Seitenpufferadreßsegment haben, und wobei das Muster einen Ladebefehl enthält, der in dem Seitenadreßsegment der Adresse zugeführt wird mit einem Bitmuster außerhalb des Adreßfeldes, welches während des Ladens des Datenblockes zugeführt wird.

26. Speicher nach Anspruch 25, wobei das Muster das Verändern des Seitenadreßsegments der empfangenen Adresse von dem Ladebefehl auf einen Wert innerhalb des Adreßfeldes enthält, während zumindest ein Datensegment in der Sequenz geladen wird.

27. Speicher nach Anspruch 15, wobei die Eingabe-/Ausgabeschaltung so betreibbar ist, daß sie ein Steuersignal empfängt, welches einen Zeittakt für die Sequenz von Adressen und Datensegmenten bereitstellt, wobei die Befehlslogik eine Logik umfaßt, um einen Impuls in dem Steuersignal zu erfassen, der eine charakteristische Pulsbreite hat, die anzeigt, daß der Block geladen ist, und wobei die Schreibsteuerschaltung so betreibbar ist, daß sie Programmierspannungen in Reaktion entweder auf die Erfassung des letzten Segmentes in dem Block oder des Impulses anlegt.

28. Speicher nach Anspruch 15, wobei die Programmierspannungen, die an den Zellen mit potentialfreiem Gate angelegt werden, ein Fowler-Nordheim-Tunneln an den zu programmierenden Zellen verursachen.

29. Speicher nach Anspruch 15, wobei die Programmierspannungen, welche an den Zellen mit potentialfreiem Gate angelegt werden, in den zu programmierenden Zellen eine Injektion heißer Elektronen verursachen.

30. Speicher nach Anspruch 15, wobei das Muster einen Adreßübergang in der Sequenz aufweist.

31. Verfahren zum Speichern eines Blockes von Daten in einem Array (10) aus Speicherelementen eines integrierten Speicherschaltkreises mit den Schritten:

Ausführen eines Vorgangs zum Speichern des Datenblockes in Reaktion auf einen Strom von Adressen und Datensegmenten, welche durch die Eingabe-/Ausgabeschaltung (25, 29, 31) empfangen werden, welche mit dem Array verbunden ist,
während des Vorgangs Überwachen des Stroms von Adressen und Datensegmenten, um ein Muster ($A_x$, $A_x$; $D_x$, $D_x$) in dem Strom zu erfassen, welches ein Ende des Blockes von Daten anzeigt, wobei das Muster zumindest Adressen oder Daten umfaßt, welche an der Eingabe/Ausgabeschaltung empfangen wurden.

32. Verfahren nach Anspruch 31, wobei der integrierte Speicherschaltkreis eine Speichereinrichtung mit potentialfreiem Gate ist und wobei der Datenblock aus weniger als einer Seite oder aus einer Seite in der Speichereinrichtung mit potentialfreiem Gate besteht, wobei das Verfahren weiterhin aufweist:

Zuführen (60, 61, 62) eines Befehls, der für die Speichereinrichtung einen automatischen Programmiervorgang anzeigt,
nach dem Zuführen des Befehls Zuführen des Stromes von Adressen (A0, A1 ...) und Datensegmenten (D0, D1 ...), und Speichern der zugeführten Segmente in einem Seitenpuffer (31),

nach Erfassung des Musters Ausführen eines Programmierungsvorgangs (63), um den Datenblock von dem Seitenpuffer zu speichern.

33. Verfahren nach Anspruch 32, wobei das Muster zwei übereinstimmende Adressen in der Sequenz in dem Strom aufweist.

34. Verfahren nach Anspruch 32, wobei das Muster eine Sequenz von zwei übereinstimmenden Adressen und Datensegmenten in dem System aufweist.

35. Verfahren nach Anspruch 32, wobei das Muster eine Adresse in dem Strom umfaßt, welche mit einer zuvor spezifizierten Befehlsadresse übereinstimmt.

36. Verfahren nach Anspruch 32, wobei Positionen für zu speichernde Daten durch Adressen innerhalb eines Adreßfeldes gekennzeichnet werden, wobei die Adressen ein Seitenadreßsegment und ein Seitenpufferadreßsegment haben, und wobei das Muster einen Startbefehl umfaßt, der in dem Seitenadreßsegment der Adresse zugeführt wird und ein Bitmuster außerhalb des Adreßfeldes aufweist, welches nach dem Laden des Datenblockes zugeführt wird.

37. Verfahren nach Anspruch 32, wobei Positionen für zu speichernde Daten durch Adressen innerhalb eines Adreßfeldes gekennzeichnet werden, und wobei die Adressen ein Seitenadreßsegment ein Seitenpufferadreßsegment haben, und wobei das Muster einen Ladebefehl aufweist, der in dem Adreßsegment der Adresse zugeführt wird und der ein Bitmuster außerhalb des Adreßfeldes aufweist, welches während des Ladens des Datenblockes zugeführt wird, und mit einer Veränderung in dem Seitenadreßsegmentfeld auf einen Wert innerhalb des Adreßfeldes.

38. Verfahren nach Anspruch 37, wobei das Muster ein Verändern des Seitenadreßsegmentes der von dem Ladebefehl empfangenen Adresse auf den Wert innerhalb des Adreßfeldes umfaßt, während ein letztes Datensegment in der Sequenz geladen wird.

39. Verfahren nach Anspruch 32, wobei der Schritt des Speicherns das Speichern des Datenblockes in paralleler Form aufweist.

40. Verfahren nach Anspruch 32, welches das automatische Verifizieren der Speicherung des Datenblockes sowie das erneute Versuchen der Speicherung umfaßt, falls ein Fehler festgestellt wird.

41. Verfahren nach Anspruch 32, wobei das Muster einen Adreßübergang in dem Strom aufweist.

**Revendications**

1. Mémoire à circuit intégré, comprenant :

   une matrice (10) d'éléments de stockage ;
   un circuit d'entrée/sortie (25, 29, 31), ayant des entrées pour recevoir des adresses et des données et couplées à la matrice, pour lire et stocker des segments de données dans la matrice en réponse à des adresses et à des données sur les entrées ; et
   un système logique de commande (37, 35), couplé au circuit d'entrée/sortie, ayant pour fonction d'exécuter un traitement de stockage d'un bloc de données en réponse à une séquence d'adresses et de segments de données reçue sur le circuit d'entrée/sortie, comportant un système logique (37) pour surveiller la séquence afin de détecter une configuration indiquant une fin du bloc de données, la configuration comportant au moins l'une d'adresses et de données reçues sur le circuit d'entrée/sortie.

2. Mémoire selon la revendication 1, dans laquelle la configuration comporte des adresses correspondantes consécutives, et le système logique de commande comporte une mémoire d'adresses et un comparateur pour mettre en correspondance une adresse reçue avec une adresse dans la mémoire.

3. Mémoire selon la revendication 1, dans laquelle la configuration comporte des adresses et des segments de données correspondants consécutifs, et le système logique de commande comporte une mémoire d'adresses et de segments de données et un comparateur pour mettre en correspondance une adresse reçue et un segment de données avec une adresse et un segment de données contenus dans la mémoire.

4. Mémoire selon la revendication 1, dans laquelle des emplacements destinés à des données devant être stockées sont identifiés par des adresses dans un champ d'adresse, et la configuration contient une adresse de commande, extérieure au champ d'adresse, et le système logique de commande comporte une mémoire pour l'adresse de commande et un comparateur pour mettre en correspondance une adresse reçue avec l'adresse de commande dans la mémoire.

5. Mémoire selon la revendication 1, dans laquelle des emplacements destinés à des données devant être stockées sont identifiés par des adresses dans un champ d'adresse, les adresses ayant un segment d'ordre supérieur et un segment d'ordre inférieur, et la configuration comporte une commande de départ délivrée dans le segment d'ordre supérieur de l'adresse comprenant une configuration de bits extérieure au champ d'adresse, délivrée après le chargement du bloc de données.

6. Mémoire selon la revendication 1, dans laquelle des emplacements destinés à des données devant être stockées sont identifiés par des adresses dans un champ d'adresse, les adresses ayant un segment d'ordre supérieur et un segment d'ordre inférieur, et la configuration comporte une commande de chargement délivrée dans le segment d'ordre supérieur de l'adresse comprenant une configuration de bits extérieure au champ d'adresse, délivrée pendant le chargement du bloc de données.

7. Mémoire selon la revendication 6, dans laquelle la configuration comporte un changement du segment d'ordre supérieur de l'adresse reçue depuis la commande de chargement en la valeur contenue dans le champ d'adresse pendant le chargement d'un dernier segment de données dans la séquence.

8. Mémoire selon la revendication 1, dans laquelle la matrice comprend des cellules de mémoire à grille flottante.

9. Mémoire selon la revendication 1, comportant un automate fini (19), sensible au système logique de commande, pour automatiquement programmer et vérifier la programmation du bloc de données après la détection du dernier segment dans le bloc.

10. Mémoire selon la revendication 1, dans laquelle la matrice comprend des cellules de mémoire à grille flottante, et le circuit d'entrée/sortie comporte un automate fini (19), sensible au système logique de commande, pour automatiquement programmer et vérifier la programmation du bloc de données après la détection du dernier segment dans le bloc.

11. Mémoire selon la revendication 10, dans laquelle le circuit d'entrée/sortie comporte des ressources couplées à l'automate fini pour appliquer aux cellules à grille flottante des potentiels provoquant un effet tunnel de Fowler-Nordheim dans des cellules devant être programmées.

12. Mémoire selon la revendication 10, dans laquelle le circuit d'entrée/sortie comporte des ressources couplées à l'automate fini pour appliquer aux cellules à grille flottante des potentiels provoquant l'injection d'électrons chauds dans des cellules devant être programmées.

13. Mémoire selon la revendication 1, dans laquelle le circuit d'entrée/sortie a pour fonction de recevoir un signal de commande établissant un rythme pour la séquence d'adresses et de segments de données, le système logique de commande comportant un système logique pour détecter une impulsion dans le signal de commande ayant une largeur d'impulsion caractéristique indiquant que le bloc est chargé, et comportant un automate fini, sensible au système logique de commande, pour automatiquement programmer et vérifier la programmation du bloc de données après la détection du dernier segment dans le bloc ou de l'impulsion.

14. Mémoire selon la revendication 1, dans laquelle la configuration comprend une transition d'adresse dans la séquence.

15. Mémoire selon la revendication 1, dans laquelle la mémoire est un circuit de mémoire à grille flottante sur un substrat semiconducteur, et la matrice (10) comporte au moins M lignes et N colonnes (120, 135, 150, 151) de cellules à grille flottante, la mémoire comprenant en outre :

M lignes de mots (WL0... WL63, WL0'... WL63'), chacune couplée aux cellules à grille flottante dans l'une des M lignes de cellules à grille flottante ;
une pluralité de lignes de bits (121, 123), chacune couplée aux cellules à grille flottante dans au moins l'une des N colonnes de cellules à grille flottante ;
un tampon de page (31) dans le circuit d'entrée/sortie pour stocker le bloc de données et délivrer le bloc de données aux N colonnes de cellules à grille flottante ;
un circuit de commande d'écriture (19, 14), couplé au système logique de commande, au tampon de page et aux M lignes de mots, qui, après la détection de la configuration indiquant la fin du bloc de données, a pour fonction de délivrer des tensions de programmation à une ligne de mots sélectionnée pour programmer des données d'entrée dans une ligne de cellules à grille flottante à laquelle accède la ligne de mots sélectionnée en réponse aux données d'entrée stockées dans le tampon de page ; et
un circuit de vérification de programme, couplé au tampon de page, ayant pour fonction de vérifier que les cellules à grille flottante sont programmées avec le bloc de données dans le tampon de page.

16. Mémoire selon la revendication 15, dans laquelle le tampon de page comporte une pluralité de registres à verrouillage de bits couplés à certaines, correspondantes, de la pluralité de lignes de bits, et le circuit de vérification de programme comporte un système logique couplé au tampon de page et aux lignes de bits, pour réinitialiser les registres à verrouillage de bits à une première valeur binaire lorsque des données stockées dans une cellule à grille flottante sur une ligne de bits correspondante sont en correspondance avec une seconde valeur binaire.

17. Mémoire selon la revendication 15, dans laquelle :

une ligne de N colonnes de cellules à grille flottante comporte une première page et une seconde page ; et
le tampon de page a pour fonction de délivrer des données d'entrée à une page de cellules à grille flottante.

18. Mémoire selon la revendication 16, dans laquelle le circuit de vérification de programme comporte un système logique sensible à des données stockées provenant des cellules à grille flottante et à des données dans le tampon de page pour fournir le signal de programme vérifié lorsque toutes les cellules à grille flottante programmées satisfont à la vérification du programme.

19. Mémoire selon la revendication 16, dans laquelle le circuit de vérification de programme a pour fonction de générer un signal de programme vérifié lorsque tous les registres à verrouillage de bits stockent la première valeur binaire.

20. Mémoire selon la revendication 19, dans laquelle le circuit de commande d'écriture a pour fonction d'appliquer un potentiel de programmation de ligne de mots à une ligne de mots couplée à un ensemble sélectionné de cellules à grille flottante, et un potentiel de programmation de ligne de bits à des lignes de bits couplées à des registres à verrouillage de bits stockant la seconde valeur binaire.

21. Mémoire selon la revendication 15, dans laquelle la configuration comporte des adresses concordantes consécutives, et comportant une mémoire, couplée au circuit d'entrée/sortie, pour maintenir des adresses, et un comparateur, couplé au circuit d'entrée/sortie, pour mettre en correspondance une adresse reçue à l'instant présent avec une adresse reçue précédemment maintenue dans la mémoire.

22. Mémoire selon la revendication 15, dans laquelle la configuration comporte des adresses et des segments de données correspondants consécutifs, et comportant une mémoire, couplée au circuit d'entrée/sortie, pour maintenir des adresses et des segments de données, et un comparateur, couplé au circuit d'entrée/sortie, pour mettre en correspondance une adresse et des segments de données reçus à l'instant présent avec une adresse et un segment de données reçus précédemment et maintenus dans la mémoire.

23. Mémoire selon la revendication 15, dans laquelle des emplacements du tampon de page sont identifiés par des adresses dans le champ d'adresse, et la configuration comporte une adresse de commande extérieure au champ d'adresse, et comportant une mémoire pour l'adresse de commande et un comparateur, couplé au circuit d'entrée/sortie, pour mettre en correspondance une adresse reçue avec l'adresse de commande dans la mémoire.

24. Mémoire selon la revendication 15, dans laquelle des emplacements destinés à des données devant être stockées sont identifiés par des adresses dans un champ d'adresse, l'adresse ayant un segment d'adresse de page et un segment d'adresse de tampon de page, et la configuration comporte une commande de départ délivrée dans le segment d'adresse de page de l'adresse comprenant une configuration de bits extérieure au champ d'adresse, délivrée après le chargement du bloc de données.

25. Mémoire selon la revendication 15, dans laquelle des emplacements destinés à des données devant être stockées sont identifiés par des adresses dans un champ d'adresse, les adresses ayant un segment d'adresse de page et un segment d'adresse de tampon de page, et la configuration comporte une commande de chargement délivrée dans le segment d'adresse de page de l'adresse comprenant une configuration de bits extérieure au champ d'adresse, délivrée pendant le chargement du bloc de données.

26. Mémoire selon la revendication 25, dans laquelle la configuration comporte un changement du segment d'adresse de page de l'adresse reçue depuis la commande de chargement en la valeur contenue dans le champ d'adresse pendant le chargement d'un dernier segment de données dans la séquence.

27. Mémoire selon la revendication 15, dans laquelle le circuit d'entrée/sortie a pour fonction de recevoir un signal de commande établissant le rythme pour la séquence d'adresses et de segments de données, le système logique de commande comportant un système logique pour détecter une impulsion dans le signal de commande ayant une largeur d'impulsion caractéristique indiquant que le bloc est chargé, et dans laquelle le circuit de commande d'écriture a pour fonction d'appliquer des tensions de programmation en réponse soit à la détection du dernier segment dans le bloc, soit à l'impulsion.

28. Mémoire selon la revendication 15, dans laquelle les tensions de programmation appliquées aux cellules à grille flottante provoquent un effet tunnel de Fowler-Nordheim dans des cellules devant être programmées.

29. Mémoire selon la revendication 15, dans laquelle les tensions de programmation appliquées aux cellules à grille flottante provoquent l'injection d'électrons chauds dans des cellules devant être programmées.

30. Mémoire selon la revendication 15, dans laquelle la configuration comprend une transition d'adresse dans la séquence.

31. Procédé de stockage d'un bloc de données dans une matrice (10) d'éléments de stockage d'une mémoire à circuit intégré, comprenant les étapes consistant à :

exécuter un traitement pour stocker le bloc de données en réponse à un flux d'adresses et de segments de données reçus par un circuit d'entrée/sortie (25, 29, 31) couplé à la matrice ;
pendant le traitement, surveiller le flux d'adresses et de segments de données pour détecter une configuration ($A_x$, $A_x$ ; $D_x$, $D_x$) dans le flux qui signale une fin du bloc de données, la configuration comportant au moins l'une d'adresses et de données reçues sur le circuit d'entrée/sortie.

32. Procédé selon la revendication 31, dans lequel la mémoire à circuit intégré est un dispositif de mémoire à grille flottante et le bloc de données est constitué d'une quantité inférieure ou égale à une page dans le dispositif de mémoire à grille flottante, le procédé consistant en outre à :

délivrer (60, 61, 62) une commande qui indique une opération de programmation automatique au dispositif de mémoire ;
après avoir délivré la commande, délivrer le flux d'adresses (A0, A1, ...) et de segments de données (D0, D1, ...), et stocker les segments délivrés dans un tampon de page (31) ;
après détection de la configuration, exécuter une opération de programmation (63) pour stocker le bloc de données provenant du tampon de page.

33. Procédé selon la revendication 32, dans lequel la configuration comporte deux adresses correspondantes en séquence dans le flux.

34. Procédé selon la revendication 32, dans lequel la configuration comporte une séquence de deux adresses et de deux segments de données correspondants dans le système.

35. Procédé selon la revendication 32, dans lequel la configuration comporte une adresse dans le flux qui est en correspondance avec une adresse de commande spécifiée à l'avance.

36. Procédé selon la revendication 32, dans lequel des emplacements destinés à des données devant être stockées sont identifiés par des adresses dans un champ d'adresse, les adresses ayant un segment d'adresse de page et un segment d'adresse de tampon de page, et la configuration comporte une commande de départ délivrée dans le segment d'adresse de page de l'adresse comprenant une configuration de bits extérieure au champ d'adresse, délivrée après le chargement du bloc de données.

37. Procédé selon la revendication 32, dans lequel des emplacements destinés à des données devant être stockées sont identifiés par des adresses dans un champ d'adresse, les adresses ayant un segment d'adresse de page et un segment d'adresse de tampon de page, et la configuration comporte une commande de chargement délivrée dans le segment d'adresse de page de l'adresse comprenant une configuration de bits extérieure au champ d'adresse, délivrée pendant le chargement du bloc de données, et un changement dans le champ de segment d'adresse de page en une valeur dans le champ d'adresse.

38. Procédé selon la revendication 37, dans lequel la configuration comporte un changement du segment d'adresse de page de l'adresse reçue de la commande de chargement en la valeur contenue dans le champ d'adresse pendant le chargement d'un dernier segment de données dans la séquence.

39. Procédé selon la revendication 32, dans lequel l'étape de stockage consiste à stocker le bloc de données en parallèle.

40. Procédé selon la revendication 32, comprenant la vérification automatique du stockage du bloc de données et une nouvelle tentative de stockage si une erreur est trouvée.

41. Procédé selon la revendication 32, dans lequel la configuration comprend une transition d'adresse dans le flux.

FIG.1

CE̅

W̅E̅

O̅E̅

ADDR

DATA

50  51  52  53

100 MICROSEC

54

START PGM PROCESS

5555  2AAA  5555  A0  A1  A127

D0  D1  D127

EP 0 829 044 B1

FIG.2

(PRIOR ART)

EP 0 829 044 B1

FIG.3

PAD 400

ADDR BUFFER 401

402 → A(i)

CLK M

CLK S

403

404

405

406

407

408

409

410

411

412 → ADMTCH(i)

## FIG.4

ADMTCH 0
ADMTCH 1

415

ADMTCH 2
ADMTCH 3

416

ADMTCH 4
ADMTCH 5

417

ADMTCH 6
ADMTCH 7

418

ADMTCH N-2
ADMTCH N-1

419

420

421

CMP

422

423

424 → MATCH

## FIG.5

FIG.6

FIG.7

FIG.8

FIG.9

EP 0 829 044 B1

ERASE SECTOR [700]

ERASE VERIFY [701]

SET PAGE NO. AND SEGMENT NO. [702]

LOAD PAGE BUFFER UNTIL PATTERN MATCH [703]

VERIFY PAGE, TURN OFF PASSED BITS [704]

PROGRAM PAGE (SET BITS) [705]

READ PROGRAMMED DATA AND STORE IN SENSE AMP DATA LATCH [715]

RESET PAGE BITS WHICH PASS VERIFY [722]

MAXIMUM RETRIES ? [710]
NO
YES

ALL PAGE BITS PASSED ? [723]
NO
YES

FINISHED SECTOR ? [725]
NO
YES

DONE [730]

FIG.10

FIG.11A

FIG.11B

EP 0 829 044 B1